# EUROPÄISCHE PATENTSCHRIFT

(11) **EP 2 035 526 B1**
(45) Veröffentlichungstag und Bekanntmachung des Hinweises auf die Patenterteilung: **17.11.2021**
(21) Anmeldenummer: 07765609.8
(22) Anmeldetag: 25.06.2007
(51) Int. Cl.: C09K 11/06, H05B 33/14, C07F 15/00

(54) **VERWENDUNG VON ÜBERGANGSMETALLCARBENKOMPLEXEN, DIE KEINE CYCLOMETALLIERUNG ÜBER NICHT-CARBENE ENTHALTEN, IN OLEDS**
USE IN OLEDS OF TRANSITION METAL CARBENE COMPLEXES THAT CONTAIN NO CYCLOMETALLATION VIA NON-CARBENES
UTILISATION DANS DES DIODES ÉLECTROLUMINESCENTES ORGANIQUES DE COMPLEXES CARBÈNE -MÉTAUX DE TRANSITION QUI NE CONTIENNENT PAS DE CYCLOMÉTALLATION PAR L'INTERMÉDIAIRE DE NON CARBÈNES

(30) Priorität: 26.06.2006 EP 06116093
(43) Veröffentlichungstag der Anmeldung: 18.03.2009
(73) Patentinhaber: UDC Ireland Limited, Ballycoolin, Dublin 15 (IE)
(72) Erfinder: FUCHS, Evelyn, 68199 Mannheim (DE); MOLT, Oliver, 69493 Hirschberg (DE); LENNARTZ, Christian, 67105 Schifferstadt (DE); RUDOLPH, Jens, 67547 Worms (DE); KAHLE, Klaus, 67069 Ludwigshafen (DE); SCHILDKNECHT, Christian, 67125 Dannstadt-Schauernheim (DE); STRASSNER, Thomas, 01156 Dresden (DE); MOONEN, Nicolle, 68163 Mannheim (DE)
(74) Vertreter: Maiwald Patent- und Rechtsanwaltsgesellschaft mbH
(86) Internationale Anmeldenummer: PCT/EP2007/056334
(87) Internationale Veröffentlichungsnummer: WO 2008/000727

(56) Entgegenhaltungen:
- WO-A-2005/019373
- WO-A-2005/113704
- DE-A1-102004 040 005
- DE-A1-102004 057 072
- LAI S-W ET AL: "Luminescent metal complexes derived from carbene and related ligands: tuning excited-state properties with metal-carbon multiple bonds" JOURNAL OF ORGANOMETALLIC CHEMISTRY, ELSEVIER-SEQUOIA S.A. LAUSANNE, CH, Bd. 617-618, 15. Januar 2001 (2001-01-15), Seiten 133-140, XP004315036 ISSN: 0022-328X
- XUE W-M ET AL: "Spectroscopic and excited-state properties of luminescent rhenium (I) N-heterocyclic carbene complexes containing aromatic diimine ligands" ORGANOMETALLICS, WASHINGTON, DC, US, Bd. 17, 1998, Seiten 1622-1630, XP002309657 ISSN: 0276-7333
- LIU Q-X ET AL: "Synthesis, crystal structure and photophysical properties of N-heterocyclic carbene Pd(II), Pt(II) complexes and iodine adduct" POLYHEDRON, PERGAMON PRESS, OXFORD, GB, Bd. 22, 15. Juni 2003 (2003-06-15), Seiten 1515-1521, XP002309655 ISSN: 0277-5387
- None

## Beschreibung

Die vorliegende Erfindung betrifft die Verwendung von Übergangsmetallcarben-komplexen, worin die Verknüpfung der oder des Carbenliganden mit dem Übergangsmetall ausschließlich über Carben-Kohlenstoffatome erfolgt, in organischen Leuchtdioden, organische Leuchtdioden, enthaltend mindestens einen vorstehend genannten Übergangsmetallcarbenkomplex, eine Licht-emittierende Schicht, enthaltend mindestens einen vorstehend genannten Übergangsmetallcarbenkomplex, organische Leuchtdioden, enthaltend mindestens eine erfindungsgemäße Licht-emittierende Schicht sowie Vorrichtungen, die mindestens eine erfindungsgemäße organische Leuchtdiode enthalten.

In organischen Leuchtdioden (OLED) wird die Eigenschaft von Materialien ausgenutzt, Licht zu emittieren, wenn sie durch elektrischen Strom angeregt werden. OLEDs sind insbesondere interessant als Alternative zu Kathodenstrahlröhren und Flüssigkristalldisplays zur Herstellung von Flachbildschirmen. Aufgrund der sehr kompakten Bauweise und des intrinsisch niedrigen Stromverbrauchs eignen sich die Vorrichtungen enthaltend OLEDs insbesondere für mobile Anwendungen, z. B. für Anwendungen in Handys, Laptops, usw.

Die Grundprinzipien der Funktionsweise von OLEDs sowie geeignete Aufbauten (Schichten) von OLEDs sind z. B. in WO 2005/113704 und deren zitierten Literatur genannt.

Im Stand der Technik wurden bereits zahlreiche Materialien vorgeschlagen, die bei der Anregung durch elektrischen Strom Licht emittieren.

In WO 2005/019373 ist erstmals die Verwendung von neutralen Übergangsmetallkomplexen, die mindestens einen Carbenliganden enthalten, in OLEDs offenbart. Diese Übergangsmetallkomplexe können gemäß WO 2005/019373 in jeder Schicht eines OLEDs eingesetzt werden, wobei das Ligandgerüst oder Zentralmetall zur Anpassung an gewünschte Eigenschaften der Übergangsmetallkomplexe variiert werden kann. Beispielsweise ist der Einsatz der Übergangsmetallkomplexe in einer Blockschicht für Elektronen, einer Blockschicht für Excitonen, einer Blockschicht für Löcher oder der Licht-emittierenden Schicht des OLEDs möglich, wobei die Übergangsmetallkomplexe bevorzugt als Emittermoleküle in OLEDs eingesetzt werden.

WO 2005/113704 betrifft lumineszente Verbindungen, die Carbenliganden tragen. Gemäß WO 2005/113704 sind zahlreiche Übergangsmetallkomplexe mit verschiedenen Carbenliganden genannt, wobei die Übergangsmetallkomplexe bevorzugt als phosphoreszierendes-lichtemittierendes Material, besonders bevorzugt als Dotiersubstanz, eingesetzt werden.

Sowohl die in WO 2005/019373 als auch die in WO 2005/113704 offenbarten Übergangsmetallcarbenkomplexe weisen Carbenliganden auf, die durch Cyclometallierung an das Übergangsmetallatom gebunden sind. Dabei erfolgt die Verknüpfung des oder der Carbenliganden mit dem Übergangsmetall zum Einen über das Carbenkohlenstoffatom und des Weiteren über ein weiteres Kohlenstoff- oder Heteroatom. DE 10 2004 040005 A1 und DE 10 2004 057072 A1 beschreiben ebenfalls Übergangsmetallcarbenkomplexe.

Aufgabe der vorliegenden Erfindung gegenüber dem vorstehend genannten Stand der Technik ist es, weitere Übergangsmetallcarbenkomplexe für die Verwendung in OLEDs bereitzustellen, die ein ausgewogenes Eigenschaftsspektrum zeigen, z. B. gute Effizienzen, eine verbesserte Lebensdauer und höhere Stabilität.

Diese Aufgabe wird gelöst durch die Verwendung von Übergangsmetallkomplexen der allgemeinen Formel (I) in organischen Leuchtdioden, wie in den Ansprüchen angegeben. 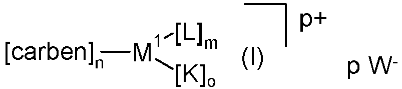 worin die Symbole die folgenden Bedeutungen aufweisen:
- M¹: Metallatom ausgewählt aus der Gruppe bestehend aus Übergangsmetallen der Gruppe IIB, IIIB, IVB, VB, VIB, VIIB, VIII des Periodensystems der Elemente (CAS-Version) und Cu, in jeder für das entsprechende Metallatom möglichen Oxidationsstufe;
- K: neutraler mono- oder bidentater Ligand;
- L: mono- oder dianionischer Ligand, der mono- oder bidentat sein kann;
- m: 0 bis 5;
- o: 0 bis 5;
- n: 1 bis 6
- p: Ladung des Komplexes: 0, 1, 2, 3, 4;
- W⁻: monoanionisches Gegenion;
wobei m, o, n und p von der Oxidationsstufe und Koordinationszahl des eingesetzten Metallatoms und von der Ladung der Liganden und der Gesamtladung des Komplexes abhängig sind,
carben
Carbenligand ausgewählt aus der Gruppe bestehend aus 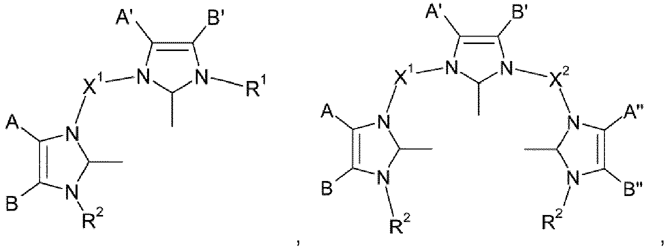 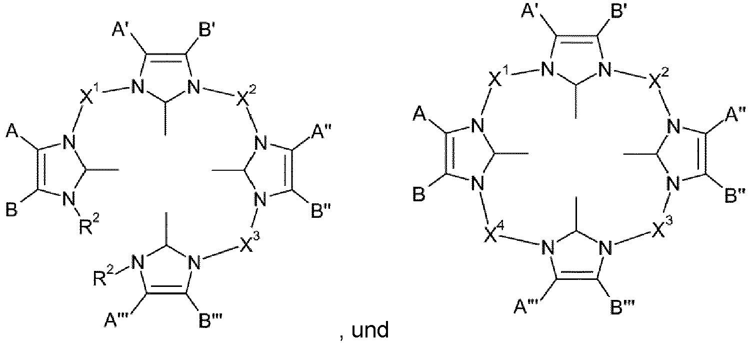 wobei
   R¹ und R²
      jeweils unabhängig voneinander Wasserstoff, Alkyl, Cycloalkyl, Heterocycloalkyl, Aryl, Heteroaryl, Aralkyl, Alkenyl, Alkinyl, wobei die Gruppen substituiert oder unsubstituiert sein können, BR³₂, NR²²₂, PR²³₂, OR²⁴, SR²⁵ oder SiR⁴₃;
   X¹, X², X³, X⁴ unabhängig voneinander CH₂, CH=CH, 1,2-Phenylen;
   R³, R⁴, R⁵, R⁶, R⁷, R⁸, R⁸, R⁹, R¹⁰, R¹¹, R²², R²³, R²⁴, R²⁵
      unabhängig voneinander Wasserstoff, Alkyl, Cycloalkyl, Heterocycloalkyl, Aryl, Aralkyl, Heteroaryl, Alkenyl, Alkinyl, Alkoxy, wobei die Gruppen substituiert oder unsubstituiert sein können, bevorzugt Wasserstoff, Alkyl, Cycloalkyl, Aryl, Alkoxy, besonders bevorzugt Wasserstoff, Alkyl oder Alkoxy;
   R¹², R¹³
      unabhängig voneinander Wasserstoff, Alkyl, Cycloalkyl, Heterocycloalkyl, Aryl, Heteroaryl, Aralkyl, Alkinyl, Alkenyl, wobei die Gruppen substituiert oder unsubstituiert sein können, oder Gruppen mit Donor- oder Akzeptorwirkung;
   A, A', A", A‴
      R¹⁸;
   B, B', B", B‴
      R¹⁹;
   wobei R¹⁸ und R¹⁹ Wasserstoff, Alkyl, Cycloalkyl, Heterocycloalkyl, Aryl, Aralkyl, Heteroaryl, Alkinyl, Alkenyl, wobei die Gruppen substituiert oder unsubstituiert sein können, oder eine Gruppe mit Donor- oder Akzeptorwirkung und wobei R¹⁸ in den Gruppen A, A', A", A'" bzw. R¹⁹ in den Gruppen B, B', B", B‴ jeweils die gleichen oder verschiedene Bedeutungen aufweisen können.

Es wurde überraschenderweise gefunden, dass ausreichend stabile, zur Verwendung in OLEDs geeignete Übergangsmetallcarbenkomplexe bereitgestellt werden können, ohne dass eine Cyclometallierung der oder des Carbenliganden über ein weiteres Kohlenstoff- oder Heteroatom erforderlich ist.

Falls verschiedene Isomere der erfindungsgemäß verwendeten Übergangsmetallcarbenkomplexe der Formel I vorliegen können, umfasst die vorliegende Erfindung sowohl jeweils die einzelnen Isomere der Übergangsmetallcarbenkomplexe der Formel I als auch Gemische verschiedener Isomere in jedem beliebigen Mischungsverhältnis. Im Allgemeinen können verschiedene Isomere der Metallkomplexe der Formel I nach dem Fachmann bekannten Verfahren, z. B. durch Chromatographie, Sublimation oder Kristallisation, getrennt werden.

Die Übergangsmetallcarbenkomplexe der Formel I können in jeder Schicht eines OLEDs eingesetzt werden, wobei das Ligandgerüst oder Zentralmetall zur Anpassung an gewünschte Eigenschaften der Metallkomplexe variiert werden kann. Beispielsweise ist der Einsatz der Übergangsmetallcarbenkomplexe der Formel I in einer Blockschicht für Elektronen, einer Blockschicht für Excitonen, einer Blockschicht für Löcher oder der Licht-emittierenden Schicht des OLEDs möglich. Bevorzugt werden die Verbindungen der Formel I als Emittermoleküle in OLEDs verwendet.

Unter einem bidentaten Liganden ist ein Ligand zu verstehen, der an zwei Stellen an das Übergangsmetallatom M¹ koordiniert ist. Im Sinne der vorliegenden Anmeldung wird der Begriff "zweizähnig" synonym mit dem Begriff "bidentat" verwendet.

Unter einem monodentaten Liganden ist ein Ligand zu verstehen, der an einer Stelle des Liganden mit dem Übergangsmetallatom M¹ koordiniert.

Unter einem tridentaten Liganden ist ein Ligand zu verstehen, der an drei Stellen an das Übergangsmetallatom M¹ koordiniert ist. Im Sinne der vorliegenden Anmeldung wird der Begriff "dreizähnig" synonym mit dem Begriff "tridentat" verwendet.

Unter einem tetradentaten Liganden ist ein Ligand zu verstehen, der an vier Stellen an das Übergangsmetallatom M¹ koordiniert ist. Im Sinne der vorliegenden Anmeldung wird der Begriff "vierzähnig" synonym mit dem Begriff "tetradentat" verwendet.

Übergangsmetallcarbenkomplexe, die ausschließlich eine Verknüpfung des oder der Carbenliganden mit dem Übergangsmetallatom über Carbenkohlenstoffatome aufweisen, sind im Stand der Technik bekannt.

W. J. Youngs et al., J. Organomet. Chem. 671 (2003) 183 bis 186 betrifft die Synthese und strukturelle Charakterisierung von zwei Bis(imidazol-2-yliden)-Pt(II)-Komplexen. Eine Anwendung dieser Komplexe ist jedoch nicht angegeben.

M. Albrecht et al., Inorganica Chimica Acta 2006, Vol 359, 6, 1929-1938 betrifft die Synthese und strukturelle Analyse von Palladium-Biscarbenkomplexen, die Bisimidazolium-Liganden tragen. Insbesondere betrifft M. Albrecht et al. mechanistische Untersuchungen der Metallierung des Bisimidazolium-Liganden.

Ch.-M. Che et al., Organometallics 1998, 17, 1622 bis 1630 betrifft eine Untersuchung der spektroskopischen Eigenschaften von lumineszierenden Rhenium(I)-N-heterocyclischen Carbenkomplexen, die aromatische Diiminliganden tragen. Die Untersuchung der spektroskopischen Eigenschaften der Komplexe dient dazu, die elektronischen Verhältnisse in diesen Komplexen besser zu verstehen. Eine Anwendung der N-heterocyclischen Rhenium(I)-Carbenkomplexe sowie mögliche elektrolumineszente Eigenschaften sind in Ch.-M. Che nicht angegeben.

Des Weiteren sind in DE-A 10 2005 058 206 N-heterocyclische Biscarbenkomplexe des Platins und Palladiums, deren Herstellung und deren Verwendung als Katalysator, insbesondere als Katalysator zur partiellen Oxidation von Kohlenwasserstoffen oder kohlenwasserstoffhaltigen Beschickungen, offenbart. DE-A 10 2005 058 206 enthält jedoch keine Information bezüglich der Lumineszenzeigenschaften der offenbarten Komplexe.

Die Eignung von Übergangsmetallcarbenkomplexen der Formel I gemäß der vorliegenden Erfindung zur Anwendung in OLEDs ist in keinem der vorstehend genannten Dokumente erwähnt. Es wurde somit gefunden, dass die Übergangsmetallcarbenkomplexe der Formel I gemäß der vorliegenden Anmeldung zum Einsatz in OLEDs geeignet sind.

Bevorzugt weisen die erfindungsgemäß verwendeten Übergangsmetallcarbenkomplexe der Formel I ein Metallatom M¹ ausgewählt aus der Gruppe bestehend aus Ir, Co, Rh, Ni, Pd, Pt, Fe, Ru, Os, Cr, Mo, W, Mn, Tc, Re und Cu auf, besonders bevorzugt Ir, Os, Ru, Rh, Pd, Co, Ni und Pt, ganz besonders bevorzugt Ir, Pt, Rh, Ru und Os, in jeder für das entsprechende Metallatom möglichen Oxidationsstufe. Insbesondere bevorzugt werden Pt(II), Pt(IV), Ir(I), Ir(III), Os(II) und Ru(II) in den erfindungsgemäß verwendeten Übergangsmetallcarbenkomplexen der Formel I eingesetzt.

Geeignete mono- oder dianionische Liganden L, die mono- oder bidentat sein können, sind die üblicherweise als mono- oder bidentate mono- oder dianionische Liganden eingesetzten Liganden. Bevorzugt werden in den Übergangsmetallcarbenkomplexen der Formel I - wenn überhaupt Liganden L vorhanden sind - monoanionische monodentate Liganden oder dianionische bidentate Liganden eingesetzt.

Üblicherweise werden als Liganden L nicht-photoaktive Liganden eingesetzt. Geeignete Liganden sind z. B. monoanionische monodentate Liganden wie Halogenide, insbesondere Cl⁻, Br, I⁻, Pseudohalogenide, insbesondere CN-, OAc-, Alkylreste, die mit dem Übergangsmetallatom M¹ über eine Sigmabindung verknüpft sind, z. B. CH₃, Alkoholate, Thiolate, Amide (R²⁶₂N⁻, wobei R²⁶ Wasserstoff oder ein substituierter oder unsubstituierter Alkyl- oder Arylrest ist); monoanionische bidentate Liganden wie Acetylacetonat und dessen Derivate sowie die in WO 02/15645 genannten bidentaten mono-anionischen Liganden und Oxid. Des Weiteren können dianionische bidentate Liganden wie Bisphenolate, Bisalkoholate, Bisthiolate, Bisazolate, Bisamide, die unsubsti-tuiert oder gegebenenfalls einfach oder mehrfach mit C₁-bis C₆-Alkylresten und/oder Donor-/Akzeptorsubstituenten substituiert sein können, bevorzugt unsubstituiertes Bisphenolat, als Liganden L eingesetzt werden.

Geeignete neutrale mono- oder bidentate Liganden K sind solche Liganden, die üblicherweise als neutrale mono- oder bidentate Liganden eingesetzt werden. Im Allgemeinen handelt es sich bei den in den Übergangsmetallcarbenkomplexen der Formel (I) eingesetzten Liganden K um nicht photoaktive Liganden. Geeignete Liganden K sind z. B. Phosphine, insbesondere Trialkylphosphine, z. B. PEt₃, PnBu₃, Triarylphosphine, z. B. PPh₃; Phosphonate und Derivate davon, Arsenate und Derivate davon, Phosphite, CO, Nitrile, Amine, Diene, die einen π-Komplex mit M¹ bilden können, z. B. 2,4-Hexadien, η⁴-Cyclooctadien und η²-Cyclooctadien (je 1,3 und 1,5), Allyl, Methallyl, Cycloocten, Norbornadien.

Geeignete monoanionische Gegenionen W⁻ sind z.B. Halogenid, Pseudohalogenid, BF₄⁻, PF₆⁻, AsF₆⁻, SbF₆⁻ oder OAc⁻, bevorzugt Cl⁻, Br, I⁻, CN⁻, OAc⁻, besonders bevorzugt Br⁻ oder I⁻.

Die Zahl n der Carbenliganden beträgt in den Übergangsmetallcarbonkomplexen der Formel I 1 bis 6. Dabei bezieht sich die Zahl n auf die Zahl der Verknüpfungen von Carbenkohlenstoffatomen mit dem Übergangsmetall M¹. Das bedeutet, für einen verbrückten Carbenliganden, der zwei Carbenkohlenstoffatome aufweist, die eine Verknüpfung zu dem Übergangsmetall M¹ ausbilden können, ist n = 2. Für einen Carbenliganden, der vier Carbenkohlenstoffatome aufweist, die eine Verknüpfung zu dem Übergangsmetallatom M¹ bilden können, ist n = 4. Für einen Übergangsmetallcarbonkomplex der z.B. drei Carbenliganden, die zwei Carbenkohlenstoffatome aufweisen, die eine Verknüpfung zu dem Übergangsmetallatom M¹ bilden können, enthält, ist n = 6. Bevorzugt bedeutet n in den Übergangsmetallcarbenkomplexen der Formel I 4 bis 6, besonders bevorzugt 4 oder 6. Enthält der Übergangsmetallcarbenkomplex der Formel I mehr als einen Carbenliganden, so können die Carbenliganden in dem Übergangsmetallcarbenkomplex der Formel I gleich oder verschieden sein.

Die Zahl m der monoanionischen oder dianionischen mono- oder bidentaten Liganden L beträgt in dem Übergangsmetallcarbenkomplex der Formel I 0 bis 5, bevorzugt 0 bis 2. Ist m > 1, können die Liganden L gleich oder verschieden sein, bevorzugt sind sie gleich. Dabei bezieht sich die Zahl m auf die Zahl der Verknüpfungen mit dem Übergangsmetall M¹. Das bedeutet, für einen bidentaten Liganden L, der zwei Positionen aufweist, die eine Verknüpfung zu dem Übergangsmetall M¹ ausbilden können, ist m = 2.

Die Zahl o der neutralen Liganden K in den Übergangsmetallcarbenkomplexen der Formel I beträgt 0 bis 5, bevorzugt 0 bis 2, besonders bevorzugt 0. Ist o > 1, können die Liganden K gleich oder verschieden sein, bevorzugt sind sie gleich.

Die Zahl p gibt die Ladung des Übergangsmetallkomplexes an, der neutral sein kann (p = 0) oder positiv geladen sein kann (p = 1, 2, 3 oder 4, bevorzugt 1, 2 oder 3, besonders bevorzugt 1 oder 2). Besonders bevorzugt ist p 0, 1 oder 2. Gleichzeitig gibt die Zahl p die Zahl der monoanionischen Gegenionen W⁻ an. Handelt es sich bei dem Übergangsmetallcarbenkomplex der Formel I um einen neutralen Übergangsmetallcarbenkomplex, bedeutet p = 0. Ist der Übergangsmetallkomplex positiv geladen, so entspricht die Zahl p der monoanionischen Gegenionen der positiven Ladung des Übergangsmetallcarbenkomplexes.

Die Anzahl der Liganden carben, K und L und die Zahl der monoanionischen Gegenionen W⁻, d. h. n, o, m und p, sind abhängig von der Oxidationsstufe und Koordinationszahl des eingesetzten Metallatoms M¹ sowie von der Ladung der Liganden und der Gesamtladung des Komplexes.

Im Sinne der vorliegenden Anmeldung haben die Begriffe Arylrest oder -gruppe, Heteroarylrest oder -gruppe, Alkylrest oder -gruppe, Cycloalkylrest oder -gruppe, Heterocycloalkylrest oder -gruppe, Alkenylrest oder -gruppe, Alkinylrest oder -gruppe, Aralkylrest oder ―gruppe, Aminogruppe und Gruppen mit Donor- und/oder Akzeptorwirkung die folgenden Bedeutungen:
Unter einem Arylrest (oder -gruppe) ist ein Rest mit einem Grundgerüst von 6 bis 30 Kohlenstoffatomen, bevorzugt 6 bis 18 Kohlenstoffatomen zu verstehen, der aus einem aromatischen Ring oder mehreren kondensierten aromatischen Ringen aufgebaut ist. Geeignete Grundgerüste sind zum Beispiel Phenyl, Naphthyl, Anthracenyl oder Phenanthrenyl. Dieses Grundgerüst kann unsubstituiert sein (d. h., dass alle Kohlenstoffatome, die substituierbar sind, Wasserstoffatome tragen), oder an einer, mehreren oder allen substituierbaren Positionen des Grundgerüsts substituiert sein. Geeignete Substituenten sind zum Beispiel Alkylreste, bevorzugt Alkylreste mit 1 bis 8 Kohlenstoffatomen, besonders bevorzugt Methyl, Ethyl oder i-Propyl, Arylreste, bevorzugt C₆-Arylreste, die wiederum substituiert oder unsubstituiert sein können, Heteroarylreste, bevorzugt Heteroarylreste, die mindestens ein Stickstoffatom enthalten, besonders bevorzugt Pyridylreste, Alkenylreste, bevorzugt Alkenylreste, die eine Doppelbindung tragen, besonders bevorzugt Alkenylreste mit einer Doppelbindung und 1 bis 8 Kohlenstoffatomen, oder Gruppen mit Donor- oder Akzeptorwirkung. Geeignete Gruppen, mit Donoroder Akzeptorwirkung sind nachstehend genannt. Ganz besonders bevorzugt tragen die Arylreste Substituenten ausgewählt aus der Gruppe bestehend aus Methyl, F, Cl, CN, Aryloxy und Alkoxy, Sulfonyl, Heteroaryl. Bevorzugt ist der Arylrest oder die Arylgruppe ein C₆-C₁₈-Arylrest, besonders bevorzugt ein C₆-Arylrest, der gegebenenfalls mit mindestens einem oder mehreren der vorstehend genannten Substituenten substituiert ist. Besonders bevorzugt weist der C₆-C₁₈-Arylrest, bevorzugt C₆-Arylrest, keinen, einen, zwei oder drei der vorstehend genannten Substituenten auf, wobei im Falle eines C₆-Arylrests der eine Substituent in ortho-, meta- oder para-Position zur weiteren Verknüpfungsstelle des Arylrestes angeordnet ist, und - im Falle von zwei Substituenten - können diese jeweils in meta-Position oder ortho-Position zur weiteren Verknüpfungsstelle des Arylrestes angeordnet sein oder ein Rest ist in ortho-Position und ein Rest in meta-Position angeordnet oder ein Rest ist in ortho- oder meta-Position angeordnet und der weitere Rest ist in para-Position angeordnet. Im Falle von drei Substituenten sind diese bevorzugt in ortho- (zwei der drei Substituenten) und p-Position (dritter Substituent) zur weiteren Verknüpfungsstelle des Arylrests ange-ordnet.

Unter einem Heteroarylrest oder einer Heteroarylgruppe sind Reste zu verstehen, die sich von den vorstehend genannten Arylresten dadurch unterscheiden, dass in dem Grundgerüst der Arylreste mindestens ein Kohlenstoffatom durch ein Heteroatom ersetzt ist. Bevorzugte Heteroatome sind N, O und S. Ganz besonders bevorzugt sind ein oder zwei Kohlenstoffatome des Grundgerüsts der Arylreste durch Heteroatome ersetzt. Insbesondere bevorzugt ist das Grundgerüst ausgewählt aus Systemen wie Pyridin und fünfgliedrigen Heteroaromaten wie Pyrrol, Furan, Pyrazol, Imidazol, Thiophen, Oxazol, Thiazol. Das Grundgerüst kann an einer, mehreren oder allen substituierbaren Positionen des Grundgerüsts substituiert sein. Geeignete Substituenten sind dieselben, die bereits bezüglich der Arylgruppen genannt wurden.

Unter einem Alkylrest oder einer Alkylgruppe ist ein Rest mit 1 bis 20 Kohlenstoffatomen, bevorzugt 1 bis 10 Kohlenstoffatomen, besonders bevorzugt 1 bis 8, ganz besonders bevorzugt 1 bis 4 Kohlenstoffatomen zu verstehen. Dieser Alkylrest kann verzweigt oder unverzweigt sein und gegebenenfalls mit einem oder mehreren Heteroatomen, bevorzugt Si, N, O oder S, besonders bevorzugt N, O oder S, unterbrochen sein. Des Weiteren kann dieser Alkylrest mit einem oder mehreren der bezüglich der Arylgruppen genannten Substituenten substituiert sein. Es ist ebenfalls möglich, dass der Alkylrest eine oder mehrere (Hetero-)-Arylgruppen trägt. Dabei sind alle der vorstehend aufgeführten (Hetero-)Arylgruppen geeignet. Besonders bevorzugt sind die Alkylreste ausgewählt aus der Gruppe bestehend aus Methyl, Ethyl, iso-Propyl, n-Propyl, n-Butyl, iso-Butyl und tert-Butyl, ganz besonders bevorzugt sind Methyl, iso-Propyl und n-Butyl.

Unter einem Cycloalkylrest oder einer Cycloalkylgruppe ist ein Rest mit 3 bis 20 Kohlenstoffatomen, bevorzugt 3 bis 10 Kohlenstoffatomen, besonders bevorzugt 3 bis 8 Kohlenstoffatomen zu verstehen. Dieses Grundgerüst kann unsubstituiert sein (d. h., dass alle Kohlenstoffatome, die substituierbar sind, Wasserstoffatome tragen), oder an einer, mehreren oder allen substituierbaren Positionen des Grundgerüsts substituiert sein. Geeignete Substituenten sind die bereits vorstehend bezüglich der Arylreste genannten Gruppen. Beispiele für geeignete Cycloalkylreste sind Cyclopropyl, Cyclopentyl und Cyclohexyl.

Unter einem Heterocycloalkylrest oder einer Heterocycloalkylgruppe sind Reste zu verstehen, die sich von den vorstehend genannten Cycloalkylresten dadurch unterscheiden, dass in dem Grundgerüst der Cycloalkylreste mindestens ein Kohlenstoffatom durch ein Heteroatom ersetzt ist. Bevorzugte Heteroatome sind N, O und S. Ganz besonders bevorzugt sind ein oder zwei Kohlenstoffatome des Grundgerüsts der Cycloalkylreste durch Heteroatome ersetzt. Beispiele für geeignete Heterocycloalkylreste sind Reste abgeleitet von Pyrrolidin, Piperidin, Piperazin, Tetrahydrofuran, Dioxan.

Unter einem Aralkylrest (oder -gruppe) ist ein Rest mit einem Grundgerüst von 6 bis 30 Kohlenstoffatomen, bevorzugt 6 bis 18 Kohlenstoffatomen zu verstehen, der unsubstutiert oder mit den bezüglich der Arylgruppen genannten Resten substituiert sein kann. Geeignete Aralkylgruppen sind z.B. Benzyl, Phenylethyl und Phenylpropyl.

Unter einem Alkenylrest oder einer Alkenylgruppe ist ein Rest zu verstehen, der den vorstehend genannten Alkylresten mit mindestens zwei Kohlenstoffatomen entspricht, mit dem Unterschied, dass mindestens eine C-C-Einfachbindung des Alkylrests durch eine C-C-Doppelbindung ersetzt ist. Bevorzugt weist der Alkenylrest eine oder zwei Doppelbindungen auf.

Unter einem Alkinylrest oder einer Alkinylgruppe ist ein Rest zu verstehen, der den vorstehend genannten Alkylresten mit mindestens zwei Kohlenstoffatomen entspricht, mit dem Unterschied, dass mindestens eine C-C-Einfachbindung des Alkylrests durch eine C-C-Dreifachbindung ersetzt ist. Bevorzugt weist der Alkinylrest eine oder zwei Dreifachbindungen auf.

Unter einer Aminogruppe ist eine Gruppe der allgemeinen Formel -NR'R" zu ver-stehen, wobei R' und R" unabhängig voneinander Wasserstoff, Alkyl oder Aryl bedeuten können. Des Weiteren können R' und R" gemeinsam mit dem N-Atom einen Ring bilden, bevorzugt einen 5- oder 6-gliedrigen Ring. Der Ring kann gesättigt oder un-gesättigt sein und gegebenenfalls mit Alkyl- oder Arylgruppen substituiert sein. Geeignete Alkyl- und Arylgruppen sind vorstehend genannt.

Die Begriffe Alkylen, Arylen, Heteroarylen, Alkinylen und Alkenylen haben im Sinne der vorliegenden Anmeldung die bezüglich der Alkyl-, Aryl-, Heteroaryl-, Alkinyl- und Alkenylreste genannten Bedeutungen mit dem Unterschied, dass die Alkylen-, Arylen-, Heteroarylen-, Alkinylen- und Alkenylengruppen zwei Bindungsstellen zu Atomen des Liganden der Formel II aufweisen.

Bevorzugte Alkylengruppen sind (CR⁴₂)ₙ, wobei R⁴ H oder Alkyl, bevorzugt H, Methyl oder Ethyl, besonders bevorzugt H und n 1 bis 3, bevorzugt 1 oder 2, besonders bevorzugt 1 bedeutet. Ganz besonders bevorzugt ist die Alkylengruppe CH₂.

Unter einer Gruppe oder einem Substituenten mit Donor- oder Akzeptorwirkung sind im Sinne der vorliegenden Anmeldung die folgenden Gruppen zu verstehen:
Unter Gruppen mit Donorwirkung sind Gruppen zu verstehen, die einen +I- und/oder +M-Effekt aufweisen, und unter Gruppen mit Akzeptorwirkung sind Gruppen zu verstehen, die einen -I- und/oder -M-Effekt aufweisen. Geeignete Gruppen, mit Donor- oder Akzeptorwirkung sind Halogenreste, bevorzugt F, Cl, Br, besonders bevorzugt F, Alkoxyreste, Aryloxyreste, Carbonylreste, Esterreste, sowohl Oxycarbonyl als auch Carbonyloxy, Aminogruppen, Amidreste, CH₂F-Gruppen, CHF₂-Gruppen, CF₃-Gruppen, CN-Gruppen, Thiogruppen, Sulfonsäuregruppen, Sulfonsäureestergruppen, Boronsäuregruppen, Boronsäureestergruppen, Phosphonsäuregruppen, Phosphon-säureestergruppen, Phosphinreste, Sulfoxidreste, Sulfonylreste, Sulfidreste, Nitrogruppen, OCN, Boranreste, Silylgruppen, Stannatreste, Iminogruppen, Hydrazinreste, Hydrazonreste, Oximreste, Nitrosogruppen, Diazogruppen, Phosphinoxidgruppen, Hydroxygruppen oder SCN-Gruppen. Ganz besonders bevorzugt sind F, Cl, CN, Aryloxy, Alkoxy, Amino, CF₃-Gruppen, Sulfonyl und Heteroaryl.

Die Arylreste oder -gruppen, Heteroarylreste oder -gruppen, Alkylreste oder -gruppen, Cycloalkylreste oder -gruppen, Heterocycloalkylreste oder -gruppen, Alkenylreste oder -gruppen, Alkinylreste oder -gruppen, Aralkylreste oder -gruppen, Aminogruppen und Gruppen mit Donor- und/oder Akzeptorwirkung, sowie die Alkylen-, Arylen-, Heteroary-Ien-, Alkinylen- und Alkenylenreste oder -gruppen können substituiert oder unsubstituiert sein. Unter einer unsubstituierten Gruppe ist im Sinne der vorliegenden Anmeldung eine Gruppe zu verstehen, worin die substituierbaren Atome der Gruppe Wasserstoffatome tragen. Unter einer substituierten Gruppe ist im Sinne der vorliegenden Anmeldung eine Gruppe zu verstehen, worin ein oder mehrere substituierbare Atom(e) mindestens an einer Position anstelle eines Wasserstoffatoms einen Substituenten tragen. Geeignete Substituenten sind die vorstehend bezüglich der Arylreste oder - gruppen genannten Substituenten.

Kommen Reste mit denselben Nummerierungen mehrfach in den Verbindungen gemäß der vorliegenden Anmeldung vor, so können diese Reste jeweils unabhängig voneinander die genannten Bedeutungen aufweisen.

Erfindungsgemäß sind in den Übergangsmetallcarbenkomplexen der Formel I eingesetzte Carbenliganden ausgewählt aus 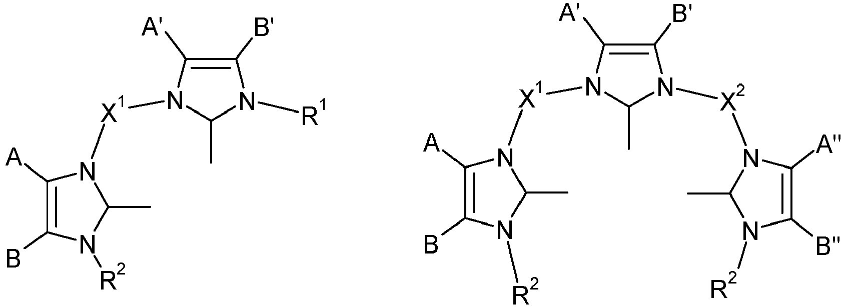 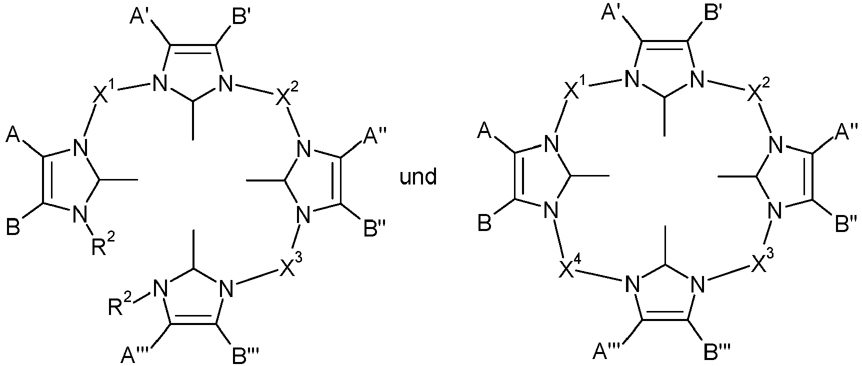 wobei die Symbole R¹, R², X¹, X², X³ und X⁴ die vorstehend genannten Bedeutungen aufweisen, und
A, A', A", A‴
   R¹⁸, und
B, B', B", B‴
   R¹⁹ bedeuten, wobei
R¹⁸ in den Gruppen A, A', A", A'" bzw. R¹⁹ in den Gruppen B, B', B", B'" jeweils die gleichen oder verschiedene Bedeutungen aufweisen können.

Bevorzugt weisen die Übergangsmetallcarbenkomplexe der Formel I Carbenliganden auf, worin die Gruppen A, A', A" und A'" sowie die Gruppen B, B', B" und B'" bzw. A und B, A' und B', A" und B" bzw. A'" und B'" jeweils die gleichen Bedeutungen aufweisen.

In den Übergangsmetallcarbenkomplexen der Formel I liegen verbrückte vor. Nachfolgend sind bevorzugt verwendete Übergangsmetallcarbenkomplexe dargestellt: 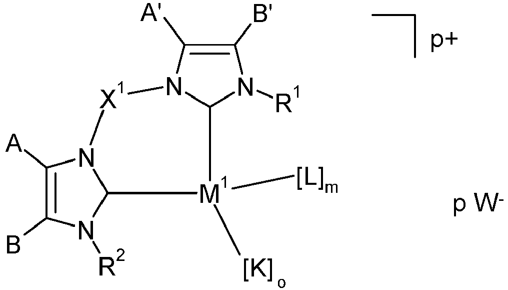 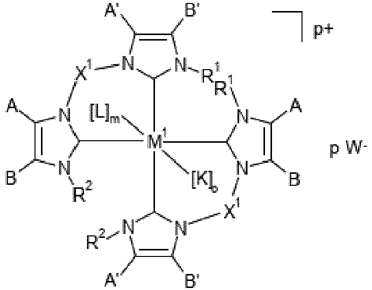 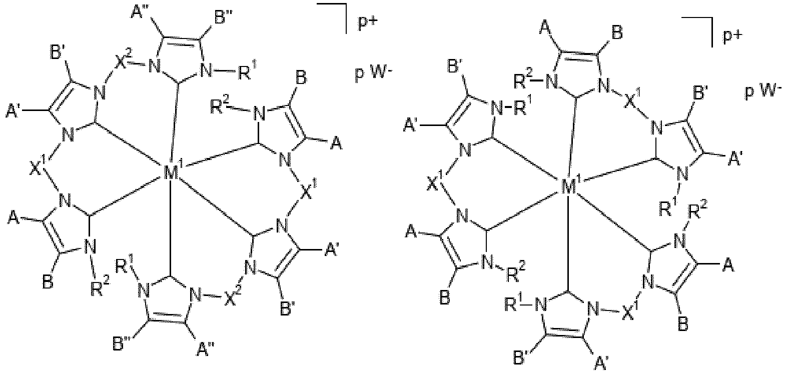 und 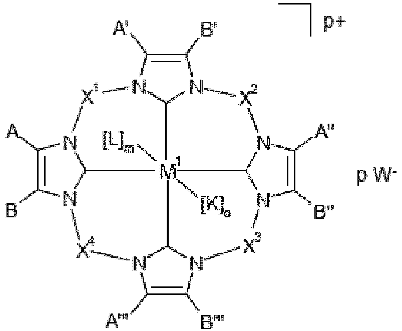 wobei die Symbole die folgenden Bedeutungen aufweisen:
- M¹: Pt, Os, Ru, Ir, besonders bevorzugt Pt(II), Pt(IV), Ir(I), Ir(III), Os(II), Ru(II);
- K: neutraler mono- oder bidentater Ligand;
- L: Cl⁻, Br⁻, I⁻, CN⁻, OAc⁻, Alkoholat, Thiolat; oder unsubstituiertes Bisphenolat, unsubstituiertes Bisalkoholat, unsubstituiertes Bisthiolat, unsubstituiertes Bisazolat oder unsubstituiertes Bisamid;
- m: 0 bis 5, bevorzugt 0 bis 3, besonders bevorzugt 0 bis 2;
- o: 0 bis 5, bevorzugt 0 bis 3, besonders bevorzugt 0 bis 2, ganz besonders bevorzugt 0;
- p: 0, 1, 2 oder 3, bevorzugt 0, 1 oder 2;
- W⁻: Halogenid, Pseudohalogenid oder OAc⁻, besonders bevorzugt Cl⁻, Br⁻, I⁻, CN⁻, OAc⁻, ganz besonders bevorzugt Br oder I⁻;
- R¹, R²: unabhängig voneinander substituiertes oder unsubstituiertes Alkyl, bevorzugt Methyl, i-Propyl, n-Butyl, substituiertes oder unsubstituiertes Cycloalkyl, bevorzugt Cyclohexyl, oder substituiertes oder unsubstituiertes Aralkyl, bevorzugt Benzyl;

A, A', A", A‴
   R¹⁸;
B, B', B", B‴
   R¹⁹; wobei
R¹⁸ in den Gruppen A, A', A", A'" bzw. R¹⁹ in den Gruppen B, B', B", B'" jeweils die unabhängig voneinander Wasserstoff oder Gruppen mit Donor- oder Akzeptorwirkung bedeuten;
X¹, X², X³, X⁴
   unabhängig voneinander CH₂, CH=CH, 1,2-Phenylen sind.

Im Folgenden sind beispielhaft geeignete Übergangsmetallcarbenkomplexe der Formel I genannt:
Tetracarbenkomplexe, z.B. 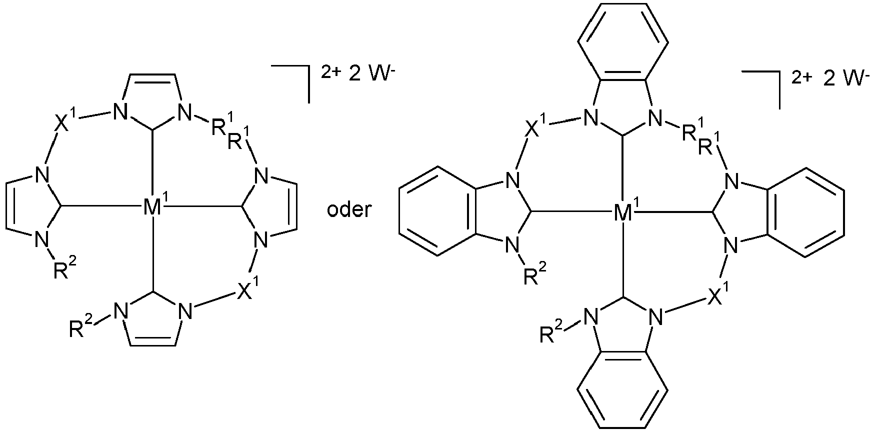 worin bedeuten:
- M¹: Pt, Pd;
- X¹: unabhängig voneinander CH₂, CH=CH, 1,2-Phenylen;
- R¹, R²: unabhängig voneinander substituiertes oder unsubstituiertes Alkyl, z.B. Methyl, iPropyl, nButyl, substituiertes oder unsubstituiertes Cycloalkyl, z.B. Cyclohexyl, substituiertes oder unsubstituiertes Aryl, z.B. 2,4,6-Methylphenyl, substituiertes oder unsubstituiertes Aralkyl, z.B. Benzyl;
- W⁻: Halogenid, Pseudohalogenid oder OAc⁻, besonders bevorzugt Cl⁻, Br⁻, I⁻, CN⁻, OAc⁻, ganz besonders bevorzugt Br oder I⁻.

Tetracarbenkomplexe, z.B. 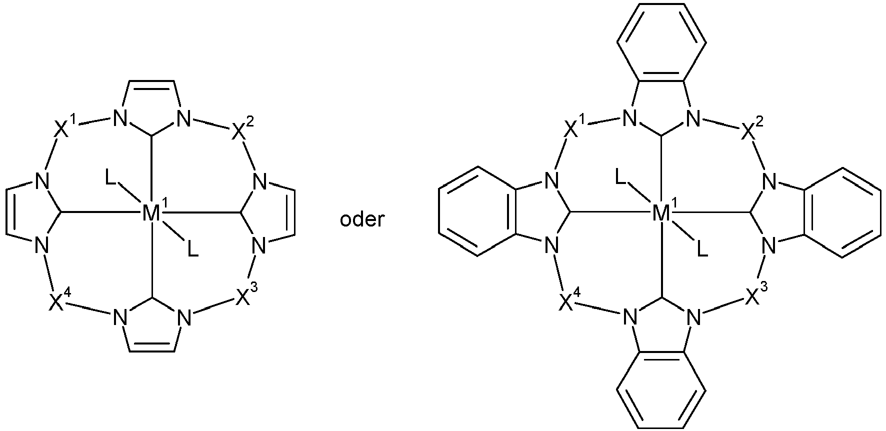 worin bedeuten:
- M¹: Os, Ru;
- X¹, X², X³, X⁴: unabhängig voneinander CH₂, CH=CH, 1,2-Phenylen:
- L: Halogenid, z.B. Br, I⁻; Pseudohalogenid, z.B. CN⁻, oder OAc⁻.

Biscarbenkomplexe, z.B. 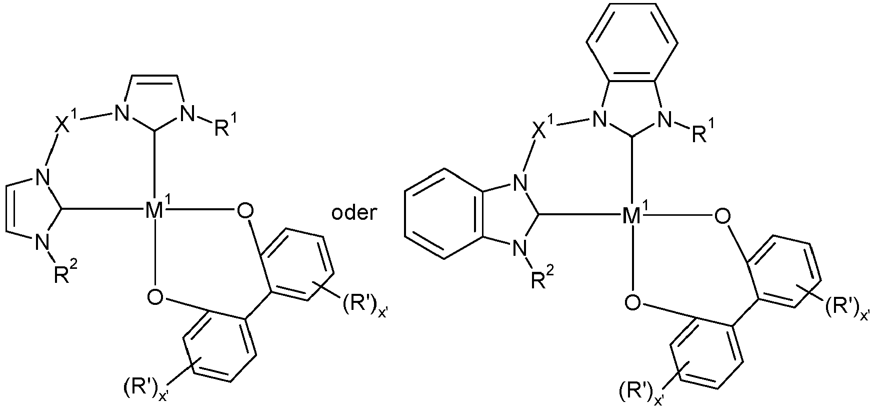 worin bedeuten:
- M¹: Pt, Pd;
- X¹: unabhängig voneinander CH₂, CH=CH, 1,2-Phenylen;
- R¹, R²: unabhängig voneinander substituiertes oder unsubstituiertes Alkyl, z.B. Methyl, iPropyl, nButyl, substituiertes oder unsubstituiertes Cycloalkyl, z.B. Cyclohexyl, substituiertes oder unsubstituiertes Aryl, z.B. 2,4,6-Methylphenyl, substituiertes oder unsubstituiertes Aralkyl, z.B. Benzyl;
- R': C₁-C₆-Alkyl oder Donor-/Akzeptorsubstituenten, bevorzugt Methyl, Ethyl iPropyl, tert.-Butyl;
- x': 0, 1, 2, 3 oder 4, bevorzugt 0, 1, 2 oder 3, besonders bevorzugt 0, 1 oder 2, ganz besonders bevorzugt 0.

Die erfindungsgemäß verwendeten Übergangsmetallcarbenkomplexe der Formel I können grundsätzlich gemäß dem Fachmann bekannten Verfahren bzw. analog zu dem Fachmann bekannten Verfahren hergestellt werden. Geeignete allgemeine Verfahren zur Herstellung von Carbenkomplexen sind z. B. in den Übersichtsartikeln W. A. Hermann et al., Advances in Organometallic Chemistry, 2001, Vol. 48, 1 bis 69, W. A. Hermann et al., Angew. Chem. 1997, 109, 2256 bis 2282 und G. Bertrand et al., Chem. Rev. 2000, 100, 39 bis 91 und der darin zitierten Literatur aufgeführt. Weitere Herstellungsverfahren sind z. B. in Ch.-M. Che et al., Organometallics 1998, 17, 1622 bis 1630, M. Albrecht et al., Inorganica Chimica Acta 2006, Vol 359, 6, 1929-1938 und W. J. Youngs et al., J. Organomet. Chem. 671 (2003) 183 bis 186, sowie in DE-A 10 2005 058 206 genannt.

Üblicherweise werden die Übergangsmetallcarbenkomplexe der Formel I aus den Carbenliganden entsprechenden Vorläufern und geeigneten, das gewünschte Metall enthaltenden, Metallkomplexen hergestellt.

Geeignete Ligandvorläufer der Carbenliganden sind dem Fachmann bekannt. Bevorzugt handelt es sich um kationische Vorstufen der allgemeinen Formel III 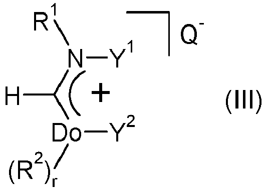 worin
- Q': ein monoanionisches Gegenion, bevorzugt Halogenid, Pseudohalogenid, BF₄⁻, BPh₄⁻, PF₆⁻, AsF₆⁻ oder SbF₆⁻ bedeutet,
und
die weiteren Reste, Symbole und Indizes in dem Ligandvorläufer der allgemeinen Formel III die vorstehend genannten Bedeutungen aufweisen.

Geeignete Ligandvorläufer sind somit z. B. Imidazoliumsalze, Bisimidazoliumsalze, Tetraimidazoliumsalze und Derivate davon.

Die Ligandvorläufer der allgemeinen Formel III können gemäß dem Fachmann bekannten Verfahren hergestellt werden. Geeignete Verfahren zur Herstellung der Ligandvorläufer sind in der vorstehend genannten und darin zitierten Literatur genannt. Einige der geeigneten Ligandvorläufer sind kommerziell erhältlich.

Bevorzugt erfolgt die Herstellung der Übergangsmetallcarbenkomplexe der Formel I durch Umsetzung von mindestens einem Ligandvorläufer der allgemeinen Formel III mit einem Metallkomplex enthaltend mindestens ein Metall M¹, wobei M¹ die vorstehend genannten Bedeutungen aufweist.

Das molare Verhältnis zwischen den Ligandvorläufern der Formel III und dem Metallkomplex enthaltend mindestens ein Metall M¹ ist von der Struktur des gewünschten Übergangsmetallcarbenkomplexes der Formel I abhängig sowie von der Art des Carbenliganden, d. h. davon, ob es sich um einen oder mehrere unverbrückte Monocarbenliganden oder um einen oder mehrere verbrückte Bis-, Tri- oder Tetracarbenliganden handelt. In dem Fall, dass n in den Übergangsmetallcarbenkomplexen der Formel I > 1 ist, ist es möglich, dass diese Übergangsmetallcarbenkomplexe durch Umsetzung des Metallkomplexes enthaltend mindestens ein Metall M¹ mit identischen Carbenliganden oder durch Umsetzung mit verschiedenen Carbenliganden erhalten werden. Somit können homo- und heteroleptische Übergangsmetallcarbenkomplexe der Formel I hergestellt werden. Geeignete Verfahren und Umsetzungsreihenfolgen zur Herstellung der verschiedenen Übergangsmetallcarbenkomplexe der Formel I sind dem Fachmann bekannt.

Bei dem Metallkomplex enthaltend mindestens ein Metall M¹ handelt es sich um ein Metallkomplex enthaltend mindestens ein Metallatom ausgewählt aus der Gruppe bestehend aus Übergangsmetallen der Gruppe IIB, IIIB, IVB, VB, VIB, VIIB, VIII des Periodensystems der Elemente (CAS-Version) und Cu, bevorzugt ausgewählt aus der Gruppe bestehend aus Ir, Co, Rh, Ni, Pd, Pt, Fe, Ru, Os, Cr, Mo, W, Mn, Tc, Re und Cu, besonders bevorzugt Ir, Os, Ru, Rh, Pd, Co und Pt, ganz besonders bevorzugt Ir, Pt, Rh, Pd, Ru und Os in jeder geeigneten für das entsprechende Metall möglichen Oxidationsstufe.

Geeignete Metallkomplexe sind dem Fachmann bekannt. Beispiele für geeignete Metallkomplexe sind: Pd(OAc)₂, Pt(cod)Cl₂, Pt(cod)Me₂, Pt(acac)₂, Pt(PPh₃)₂Cl₂, PtCl₂, [Rh(cod)Cl]₂, Rh(acac)CO(PPh₃), Rh(acac)(CO)₂, Rh(cod)₂BF₄, RhCl(PPh₃)₃, RhCl₃ x nH₂O, Rh(acac)₃, [Os(CO)₃I₂]₂, [Os₃(CO)₁₂], OsH₄ (PPh₃)₃Cp₂Os, Cp*₂Os, H₂OsCl₆ x 6H₂O, OsCl₃ × H₂O, Ru(acac)₃, RuCl₂(cod), Ru(2-methylallyl)₂(cod), [(µ-Cl)Ir(η⁴-1,5-cod)]₂, [(µ-Cl)Ir(η²-coe)₂]₂, Ir(acac)₃, IrCl₃ x nH₂O, (tht)₃IrCl₃, Ir(η³-allyl)₃, Ir(η³-metallyl)₃, worin cod Cyclooctadien, coe Cycloocten, acac Acetylacetonat und tht Tetrahydrothiophen bedeuten. Die Metallkomplexe können gemäß dem Fachmann bekannten Verfahren hergestellt werden bzw. sind kommerziell erhältlich.

Wird als Carbenligand ein verbrückter Biscarbenligand der allgemeinen Formel 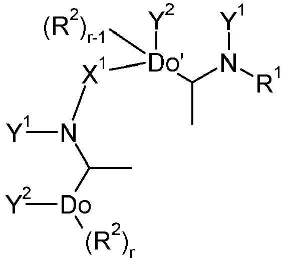 (worin die Symbole die vorstehend genannten Bedeutungen aufweisen, Do und Do' ist N)
eingesetzt, so ist es möglich, diesen mit einer etwa äquimolaren Menge eines entsprechenden Metallkomplexes enthaltend mindestens ein Metall M¹ umzusetzen, wobei die entsprechenden Biscarbenkomplexe erhalten werden. Des Weiteren ist es möglich, den Metallkomplex enthaltend mindestens ein Übergangsmetallatom M¹ mit der etwa doppelt-stöchiometrischen Menge eines oder zweier verschiedener Biscarbenliganden umzusetzen. In diesem Fall können Tetracarbenkomplexe erhalten werden. Je nachdem, ob es sich bei den eingesetzten Biscarbenliganden um gleiche oder verschiedene Biscarbenliganden handelt, können homo- oder heteroleptische Tetracarbenkomplexe erhalten werden. Die Herstellung der Tetracarbenkomplexe enthaltend zwei Biscarbenliganden kann entweder dadurch erfolgen, dass der entsprechende Metallkomplex enthaltend mindestens ein Übergangsmetallatom M¹ mit der etwa doppelt-stöchiometrischen Menge eines oder zweier verschiedener Carbenliganden umgesetzt wird oder dadurch, dass zunächst ein entsprechender Biscarbenkomplex durch Umsetzung des Metallkomplexes enthaltend mindestens ein Übergangsmetallatom M¹ mit etwa stöchiometrischen Mengen eines Biscarbenliganden umgesetzt wird und der erhaltene Biscarbenkomplex anschließend mit einer etwa stöchiometrischen Menge eines weiteren - gleichen oder verschiedenen - Biscarbenkomplexes umgesetzt wird.

Im Anschluss an die vorstehend erwähnte Umsetzung des Metallkomplexes mit einem oder mehreren Ligandvorläufern wird der erhaltene Übergangsmetallcarbenkomplex der Formel I nach dem Fachmann bekannten Verfahren aufgearbeitet und gegebenenfalls gereinigt. Üblicherweise erfolgen Aufarbeitung und Reinigung durch Extraktion, Säulenchromatographie und/oder Umkristallisation gemäß dem Fachmann bekannten Verfahren.

Die Übergangsmetallcarbenkomplexe der Formel I werden in organischen Leuchtdioden (OLEDs) verwendet. Sie eignen sich als Emittersubstanzen, da sie eine Emission (Elektrolumineszenz) im sichtbaren Bereich des elektromagnetischen Spektrums aufweisen. Mithilfe der erfindungsgemäß eingesetzten Übergangsmetallcarbenkomplexe der Formel I als Emittersubstanzen ist es möglich, Verbindungen bereitzustellen, die Elektrolumineszenz im roten, grünen sowie im blauen Bereich des elektromagnetischen Spektrums mit guter Effizienz zeigen. Dabei ist die Quantenausbeute hoch und die Stabilität der erfindungsgemäß eingesetzten Übergangsmetallcarbenkomplexe der Formel I im Device hoch.

Des Weiteren sind die erfindungsgemäß verwendeten Übergangsmetallcarbenkomplexe der Formel I als Elektronen- , Exzitonen- oder Lochblocker oder Lochleiter, Elektronenleiter, Lochinjektionsschicht oder Matrixmaterial in OLEDs geeignet, in Abhängigkeit von den eingesetzten Liganden und dem eingesetzten Zentralmetall.

Organische Leuchtdioden (OLEDs) sind grundsätzlich aus mehreren Schichten aufgebaut:
1. Anode (1)
2. Löcher-transportierende Schicht (2)
3. Licht-emittierende Schicht (3)
4. Elektronen-transportierende Schicht (4)
5. Kathode (5)

Es ist jedoch auch möglich, dass das OLED nicht alle der genannten Schichten aufweist, zum Beispiel ist ein OLED mit den Schichten (1) (Anode), (3) (Licht-emittierende Schicht) und (5) (Kathode) ebenfalls geeignet, wobei die Funktionen der Schichten (2) (Löcher-transportierende Schicht) und (4) (Elektronen-transportierende Schicht) durch die angrenzenden Schichten übernommen werden. OLEDs, die die Schichten (1), (2), (3) und (5) bzw. die Schichten (1), (3), (4) und (5) aufweisen, sind ebenfalls geeignet.

Die Übergangsmetallcarbenkomplexe der Formel I können in verschiedenen Schichten eines OLEDs eingesetzt werden. Ein weiterer Gegenstand der vorliegenden Erfindung ist daher ein OLED enthaltend mindestens einen Übergangsmetallcarbenkomplex der Formel I. Die Übergangsmetallcarbenkomplexe der Formel I werden bevorzugt in der Licht-emittierenden Schicht, besonders bevorzugt als Emittermoleküle, eingesetzt. Ein weiterer Gegenstand der vorliegenden Erfindung ist daher eine Licht-emittierende Schicht enthaltend mindestens einen Übergangsmetallcarbenkomplex der Formel I, bevorzugt als Emittermolekül. Bevorzugte Übergangsmetallcarbenkomplexe der Formel I sind vorstehend genannt.

Die erfindungsgemäß verwendeten Übergangsmetallcarbenkomplexe der Formel I können in Substanz - ohne weitere Zusätze - in der Licht-emittierenden Schicht oder einer anderen Schicht des OLEDs, bevorzugt in der Licht-emittierenden Schicht, vorliegen. Es ist jedoch ebenfalls möglich und bevorzugt, dass neben den Übergangsmetallcarbenkomplexen der Formel I weitere Verbindungen in den Schichten, bevorzugt in der Licht-emittierenden Schicht, vorliegen. Beispielsweise kann in der Licht-emittierenden Schicht ein fluoreszierender Farbstoff anwesend sein, um die Emissionsfarbe des als Emittermoleküls eingesetzten Übergangsmetallcarbenkomplexes der Formel I zu verändern. Des Weiteren kann - in einer bevorzugten Ausführungsform - ein Verdünnungsmaterial eingesetzt werden. Dieses Verdünnungsmaterial kann ein Polymer sein, zum Beispiel Poly(N-vinylcarbazol) oder Polysilan. Das Verdünnungsmaterial kann jedoch ebenfalls ein kleines Molekül sein, zum Beispiel 4,4'-N, N'-Dicarbazolbiphenyl (CDP=CBP) oder tertiäre aromatische Amine.

Die einzelnen der vorstehend genannten Schichten des OLEDs können wiederum aus 2 oder mehreren Schichten aufgebaut sein. Beispielsweise kann die Löcher-transportierende Schicht aus einer Schicht aufgebaut sein, in die aus der Elektrode Löcher injiziert werden und einer Schicht, die die Löcher von der Lochinjektionsschicht weg in die Licht-emittierende Schicht transportiert. Die Elektronen-transportierende Schicht kann ebenfalls aus mehreren Schichten bestehen, zum Beispiel einer Schicht, worin Elektronen durch die Elektrode injiziert werden, und einer Schicht, die aus der Elektroneninjektionsschicht Elektronen erhält und in die Licht-emittierende Schicht transportiert. Diese genannten Schichten werden jeweils nach Faktoren wie Energie-niveau, Temperaturresistenz und Ladungsträgerbeweglichkeit, sowie Energiedifferenz der genannten Schichten mit den organischen Schichten oder den Metallelektroden ausgewählt. Der Fachmann ist in der Lage, den Aufbau der OLEDs so zu wählen, dass er optimal an die erfindungsgemäß, bevorzugt als Emittersubstanzen, verwendeten Übergangsmetallcarbenkomplexe der Formel I angepasst ist.

Um besonders effiziente OLEDs zu erhalten, sollte das HOMO (höchstes besetztes Molekülorbital) der Loch-transportierenden Schicht mit der Arbeitsfunktion der Anode angeglichen sein und das LUMO (niedrigstes unbesetztes Molekülorbital) der elektronentransportierenden Schicht sollte mit der Arbeitsfunktion der Kathode angeglichen sein.

Ein weiterer Gegenstand der vorliegenden Anmeldung ist ein OLED enthaltend mindestens eine erfindungsgemäße Licht-emittierende Schicht. Die weiteren Schichten in dem OLED können aus einem beliebigen Material aufgebaut sein, das üblicherweise in solchen Schichten eingesetzt wird und dem Fachmann bekannt ist.

Die Anode (1) ist eine Elektrode, die positive Ladungsträger bereitstellt. Sie kann zum Beispiel aus Materialien aufgebaut sein, die ein Metall, eine Mischung verschiedener Metalle, eine Metalllegierung, ein Metalloxid oder eine Mischung verschiedener Metalloxide enthält. Alternativ kann die Anode ein leitendes Polymer sein. Geeignete Metalle umfassen die Metalle der Gruppen 11, 4, 5 und 6 des Periodensystems der Elemente sowie die Übergangsmetalle der Gruppen 8 bis 10. Wenn die Anode lichtdurchlässig sein soll, werden im Allgemeinen gemischte Metalloxide der Gruppen 12, 13 und 14 des Periodensystems der Elemente eingesetzt, zum Beispiel Indium-Zinn-Oxid (ITO). Es ist ebenfalls möglich, dass die Anode (1) ein organisches Material, zum Beispiel Polyanilin enthält, wie beispielsweise in Nature, Vol. 357, Seiten 477 bis 479 (11. Juni 1992) beschrieben ist. Zumindest entweder die Anode oder die Kathode sollten mindestens teilweise transparent sein, um das gebildete Licht auskoppeln zu können.

Geeignete Lochtransportmaterialien für die Schicht (2) des erfindungsgemäßen OLEDs sind zum Beispiel in Kirk-Othmer Encyclopedia of Chemical Technologie, 4. Auflage, Vol. 18, Seiten 837 bis 860, 1996 offenbart. Sowohl Löcher transportierende Moleküle als auch Polymere können als Lochtransportmaterial eingesetzt werden. Üblicherweise eingesetzte Löcher transportierende Moleküle sind ausgewählt aus der Gruppe bestehend aus 4,4'-Bis[N-(1-naphthyl)-N-phenyl-amino]biphenyl (a-NPD), N, N'-Diphenyl-N, N'-Bis(3-methylphenyl)-[1,1'-biphenyl]-4,4'-diamin (TPD), 1,1-Bis[(di-4-tolylamino)-phenyl]cyclohexan (TAPC), N, N'-Bis(4-methylphenyl)-N, N'-Bis(4-ethylphenyl)-[1,1'-(3,3'-dimethyl)biphenyl]-4,4'-diamin (ETPD), Tetrakis-(3-methylphenyl)-N,N,N',N'-2,5-phenylendiamin (PDA), α-Phenyl-4-N,N-diphenylaminostyrol (TPS), p-(Diethylamino)-benzaldehyddiphenylhydrazon (DEH), Triphenylamin (TPA), Bis[4-(N,N-diethylamino)-2-methylphenyl)(4-methyl-phenyl)methan (MPMP), 1-Phenyl-3-[p-(diethylamino)styryl]-5-[p-(diethylamino)phenyl]pyrazolin (PPR oder DEASP), 1,2-trans-Bis(9H-carbazol-9-yl)cyclobutan (DCZB), N,N,N',N'-tetrakis(4-methylphenyl)-(1,1'-biphenyl)-4,4'-diamin (TTB) 4,4',4"-tris(N,N-Diphenylamino)triphenylamin (TDTA) und Porphyrinverbindungen sowie Phthalocyaninen wie Kupferphthalocyanine. Üblicherweise eingesetzte Löcher transportierende Polymere sind ausgewählt aus der Gruppe bestehend aus Polyvinylcarbazolen, (Phenylmethyl)polysilanen, PEDOT (Poly(3,4-ethylendioxythiophen), bevorzugt PEDOT dotiert mit PSS (Polystyrolsulfonat), und Polyanilinen. Es ist ebenfalls möglich, Löcher transportierende Polymere durch Dotieren Löcher transportierender Moleküle in Polymere wie Polystyrol und Polycarbonat zu erhalten. Geeignete Löcher transportierende Moleküle sind die bereits vorstehend genannten Moleküle.

Geeignete Elektronentransportmaterialien für die Schicht (4) der erfindungsgemäßen OLEDs umfassen mit oxinoiden Verbindungen chelatisierte Metalle wie Tris(8-hydroxychinolato)aluminium (Alq₃), Verbindungen auf Phenanthrolinbasis wie 2,9-Dimethyl, 4,7-Diphenyl-1, 10-phenanthrolin (DDPA = BCP) oder 4,7-Diphenyl-1, 10-phenanthrolin (DPA) und Azolverbindungen wie 2-(4-Biphenylyl)-5-(4-t-butylphenyl)-1,3,4-oxadiazol (PBD) und 3-(4-Biphenylyl)-4-phenyl-5-(4-t-butylphenyl)-1,2,4-triazol (TAZ). Dabei kann die Schicht (4) sowohl zur Erleichterung des Elektronentransports dienen als auch als Pufferschicht oder als Sperrschicht, um ein Quenchen des Ex-citons an den Grenzflächen der Schichten des OLEDs zu vermeiden. Vorzugsweise verbessert die Schicht (4) die Beweglichkeit der Elektronen und reduziert ein Quenchen des Excitons.

Von den vorstehend als Lochtransportmaterialien und Elektronen transportierende Materialien genannten Materialien können einige mehrere Funktionen erfüllen. Zum Beispiel sind einige der Elektronen leitenden Materialien gleichzeitig Löcher blockende Materialien, wenn sie ein tief liegendes HOMO aufweisen.

Die Ladungstransportschichten können auch elektronisch dotiert sein, um die Transporteigenschaften der eingesetzten Materialien zu verbessern, um einerseits die Schichtdicken großzügiger zu gestalten (Vermeidung von Pinholes/Kurzschlüssen) und um andererseits die Betriebsspannung des Devices zu minimieren. Beispielsweise können die Lochtransportmaterialien mit Elektronenakzeptoren dotiert werden, zum Beispiel können Phthalocyanine bzw. Arylamine wie TPD oder TDTA mit Tetrafluorotetracyano-chinodimethan (F4-TCNQ) dotiert werden. Die Elektronentransportmaterialien können zum Beispiel mit Alkalimetallen dotiert werden, beispielsweise Alq₃ mit Lithium. Die elektronische Dotierung ist dem Fachmann bekannt und zum Beispiel in W. Gao, A. Kahn, J. Appl. Phys., Vol. 94, No. 1, 1 July 2003 (p-dotierte organische Schichten); A. G. Werner, F. Li, K. Harada, M. Pfeiffer, T. Fritz, K. Leo, Appl. Phys. Lett., Vol. 82, No. 25, 23 June 2003 und Pfeiffer et al., Organic Electronics 2003, 4, 89 - 103 offenbart.

Die Kathode (5) ist eine Elektrode, die zur Einführung von Elektronen oder negativen Ladungsträgern dient. Die Kathode kann jedes Metall oder Nichtmetall sein, das eine geringere Arbeitsfunktion aufweist als die Anode. Geeignete Materialien für die Kathode sind ausgewählt aus der Gruppe bestehend aus Alkalimetallen der Gruppe 1, zum Beispiel Li, Cs, Erdalkalimetallen der Gruppe 2, Metallen der Gruppe 12 des Periodensystems der Elemente, umfassend die Seltenerdmetalle und die Lanthanide und Aktinide. Des Weiteren können Metalle wie Aluminium, Indium, Calcium, Barium, Sama-rium und Magnesium sowie Kombinationen davon eingesetzt werden. Weiterhin können Lithium enthaltende organometallische Verbindungen oder LiF zwischen der organischen Schicht und der Kathode aufgebracht werden, um die Betriebsspannung (Operating Voltage) zu vermindern.

Das OLED gemäß der vorliegenden Erfindung kann zusätzlich weitere Schichten enthalten, die dem Fachmann bekannt sind. Beispielsweise kann zwischen der Schicht (2) und der Licht emittierenden Schicht (3) eine Schicht aufgebracht sein, die den Transport der positiven Ladung erleichtert und/oder die Bänderlücke der Schichten aneinander anpasst. Alternativ kann diese weitere Schicht als Schutzschicht dienen. In analoger Weise können zusätzliche Schichten zwischen der Licht emittierenden Schicht (3) und der Schicht (4) vorhanden sein, um den Transport der negativen Ladung zu erleichtern und/oder die Bänderlücke zwischen den Schichten aneinander anzupassen. Alternativ kann diese Schicht als Schutzschicht dienen.

In einer bevorzugten Ausführungsform enthält das erfindungsgemäße OLED zusätzlich zu den Schichten (1) bis (5) mindestens eine der im Folgenden genannten weiteren Schichten:
- eine Loch-Injektionsschicht zwischen der Anode (1) und der Löcher-transportierenden Schicht (2);
- eine Blockschicht für Elektronen und/oder Excitonen zwischen der Löcher-transportierenden Schicht (2) und der Licht-emittierenden Schicht (3);
- eine Blockschicht für Löcher und/oder Excitonen zwischen der Licht-emittierenden Schicht (3) und der Elektronen-transportierenden Schicht (4);
- eine Elektronen-Injektionsschicht zwischen der Elektronen-transportierenden Schicht (4) und der Kathode (5).

Wie bereits vorstehend erwähnt, ist es jedoch auch möglich, dass das OLED nicht alle der genannten Schichten (1) bis (5) aufweist, zum Beispiel ist ein OLED mit den Schichten (1) (Anode), (3) (Licht-emittierende Schicht) und (5) (Kathode) ebenfalls geeignet, wobei die Funktionen der Schichten (2) (Löcher-transportierende Schicht) und (4) (Elektronen-transportierende Schicht) durch die angrenzenden Schichten übernommen werden. OLEDs, die die Schichten (1), (2), (3) und (5) bzw. die Schichten (1), (3), (4) und (5) aufweisen, sind ebenfalls geeignet.

Dem Fachmann ist bekannt, wie er (zum Beispiel auf Basis von elektrochemischen Untersuchungen) geeignete Materialien auswählen muss. Geeignete Materialien für die einzelnen Schichten sowie geeignete OLED-Aufbauten sind dem Fachmann bekannt und z. B. in WO2005/113704 offenbart.

Des Weiteren kann jede der genannten Schichten des erfindungsgemäßen OLEDs aus zwei oder mehreren Schichten aufgebaut sein. Des Weiteren ist es möglich, dass einige oder alle der Schichten (1), (2), (3), (4) und (5) oberflächenbehandelt sind, um die Effizienz des Ladungsträgertransports zu erhöhen. Die Auswahl der Materialien für jede der genannten Schichten ist bevorzugt dadurch bestimmt, ein OLED mit einer hohen Effizienz zu erhalten.

Die Herstellung des erfindungsgemäßen OLEDs kann nach dem Fachmann bekannten Methoden erfolgen. Im Allgemeinen wird das OLED durch aufeinander folgende Dampfabscheidung (Vapor deposition) der einzelnen Schichten auf ein geeignetes Substrat hergestellt. Geeignete Substrate sind zum Beispiel Glas oder Polymerfilme. Zur Dampfabscheidung können übliche Techniken eingesetzt werden wie thermische Verdampfung, Chemical Vapor Deposition und andere. In einem alternativen Verfahren können die organischen Schichten aus Lösungen oder Dispersionen in geeigneten Lösungsmitteln beschichtet werden, wobei dem Fachmann bekannte Beschichtungstechniken angewendet werden. Zusammensetzungen, die neben dem mindestens einen Übergangsmetallcarbenkomplex der Formel I ein polymeres Material in einer der Schichten des OLEDs, bevorzugt in der Licht-emittierenden Schicht, aufweisen, werden im Allgemeinen mittels lösungsverarbeitenden Verfahren als Schicht aufgebracht.

Im Allgemeinen haben die verschiedenen Schichten folgende Dicken: Anode (1) 500 bis 5000 Å, bevorzugt 1000 bis 2000 Ä; Löcher-transportierende Schicht (2) 50 bis 1000 Å, bevorzugt 200 bis 800 Ä, Licht-emittierende Schicht (3) 10 bis 1000 Å, bevorzugt 100 bis 800 Å, Elektronen transportierende Schicht (4) 50 bis 1000 Å, bevorzugt 200 bis 800 Å, Kathode (5) 200 bis 10.000 Å, bevorzugt 300 bis 5000 Ä. Die Lage der Rekombinationszone von Löchern und Elektronen in dem erfindungsgemäßen OLED und somit das Emissionsspektrum des OLED können durch die relative Dicke jeder Schicht beeinflusst werden. Das bedeutet, die Dicke der Elektronentransportschicht sollte bevorzugt so gewählt werden, dass die Elektronen/Löcher Rekombinationszone in der Licht-emittierenden Schicht liegt. Das Verhältnis der Schichtdicken der einzelnen Schichten in dem OLED ist von den eingesetzten Materialien abhängig. Die Schichtdicken von gegebenenfalls eingesetzten zusätzlichen Schichten sind dem Fachmann bekannt.

Durch Einsatz der Übergangsmetallcarbenkomplexe der Formel I in mindestens einer Schicht des erfindungsgemäßen OLEDs, bevorzugt als Emittermolekül in der Licht-emittierenden Schicht der erfindungsgemäßen OLEDs, können OLEDs mit hoher Effizienz erhalten werden. Die Effizienz der erfindungsgemäßen OLEDs kann des Weiteren durch Optimierung der anderen Schichten verbessert werden. Beispielsweise können hoch effiziente Kathoden wie Ca, Ba oder LiF eingesetzt werden. Geformte Substrate und neue Löcher-transportierende Materialien, die eine Reduktion der Operationsspannung oder eine Erhöhung der Quanteneffizienz bewirken, sind ebenfalls in den erfindungsgemäßen OLEDs einsetzbar. Des Weiteren können zusätzliche Schichten in den OLEDs vorhanden sein, um die Energielevel der verschiedenen Schichten einzustellen und um Elektrolumineszenz zu erleichtern.

Die erfindungsgemäßen OLEDs können in allen Vorrichtungen eingesetzt werden, worin Elektrolumineszenz nützlich ist. Geeignete Vorrichtungen sind bevorzugt ausgewählt aus stationären und mobilen Bildschirmen. Stationäre Bildschirme sind z.B. Bildschirme von Computern, Fernsehern, Bildschirme in Druckern, Küchengeräten sowie Reklametafeln, Beleuchtungen und Hinweistafeln. Mobile Bildschirme sind z.B. Bildschirme in Handys, Laptops, Kameras, insbesondere Digitalkameras, Fahrzeugen sowie Zielanzeigen an Bussen und Bahnen.

Weiterhin können die Übergangsmetallcarbenkomplexe der Formel I in OLEDs mit inverser Struktur eingesetzt werden. Bevorzugt werden die erfindungsgemäß eingesetzten Übergangsmetallcarbenkomplexe der allgemeinen Formel I in diesen inversen OLEDs wiederum in der Licht-emittierenden Schicht eingesetzt. Der Aufbau von inversen OLEDs und die üblicherweise darin eingesetzten Materialien sind dem Fachmann bekannt.

Die nachfolgenden Beispiele erläutern die Erfindung zusätzlich:

### Beispiele

### A) 2,2'-Biphenolatdinatriumsalz 1

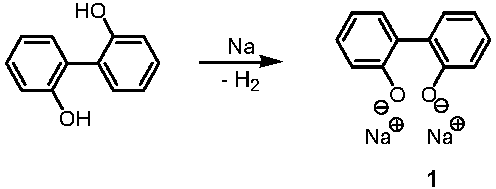

32,22 mmol elementares Natrium (0,741 g) werden in 10 mL trockenem Tetrahydrofuran vorgelegt. Zu dem Gemisch werden 16,11 mmol 2,2'-Biphenol in 10 mL trockenem Tetrahydrofuran bei Raumtemperatur getropft. Das Reaktionsgemisch wird 2 Tage bei Raumtemperatur gerührt. Danach wird der Rückstand abfiltriert und im Hochvakuum getrocknet. Es wird der weiße Feststoff 1 erhalten.

| | | |
|---|---|---|
| **Summenformel:** | C₁₂H₈O₂Na₂ | M = 230,164 g/mol |
| **Ausbeute:** | 3,274 g (88,3 % d. Th.) | |

**¹H-NMR** (ppm, d₆-DMSO, 300,13 MHz): δ = 7,28 (br, 1H, arom. CH); 7,03 (br, 1H, arom. CH); 6,74 (br, 2H, arom. CH); 6,58 (br, 2H, arom. CH); 6,30 (br, 1H, arom. CH); 6,08 (br, 1H, arom. CH)
**¹³C-NMR** (ppm, d₆-DMSO, 75,475 MHz): δ = 163,36 (Cᵢₚₛₒ-O); 129,80 (Cᵢₚₛₒ); 129,29 (arom. CH); 126,70 (arom. CH); 118,90 (arom. CH); 113,99 (arom. CH)

### B) (1,1'-Dimethyl-3,3'-methylendiimidazolin-2,2'-diyliden)platin(II)dibromid 2

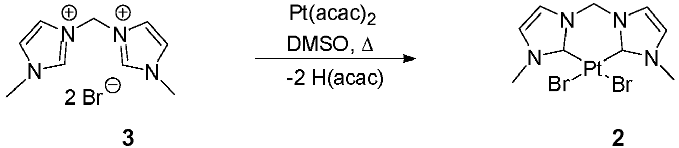

0,5 mmol Platin(II)acetylacetonat (0,197 g) werden in 3 mL Dimethylsulfoxid vorgelegt und auf 100 °C erwärmt. Dazu wird mit Hilfe einer Spritzenpumpe über 13 Stunden eine Lösung von 0,5 mmol 1,1'-Dimethyl-3,3'-methylen-diimidazoliumdibromid 3 (0,169 g) in 20 mL Dimethylsulfoxid zugegeben. Das gesamte Reaktionsgemisch wird weitere 2 Stunden bei 100 °C gerührt. Danach wird das Lösungsmittel bei 70 °C im Vakuum entfernt und der entstehende Feststoff zweimal mit wenig Wasser und zweimal mit wenig Tetrahydrofuran gewaschen. Der weiße Feststoff 2 ist noch zu trocknen.

| | | |
|---|---|---|
| **Summenformel:** | C₉H₁₂N₄PtBr₂ | M = 531,112 g/mol |
| **Ausbeute:** | 0,179 g (67,4 % d. Th.) | |
| **Schmelzpunkt:** | Zersetzung bei > 380 °C | |

**¹H** (ppm, d₆-DMSO, 300,13 MHz): δ = 7,53 (d, 2H, J = 2,0 Hz, NCHCHN); 7,31 (d, 2H, J = 2,0 Hz, NCHCHN); 6,10 (AB, 1H, J = 13,1 Hz, NCH₂N); 5,96 (AB, 1H, J = 13,1 Hz, NCH₂N); 3,84 (s, 6H, CH₃-Gruppe)

### C) (1,1'-Dimethyl-3,3'-methylendiimidazolin-2,2'-diyliden)platin(II)ditetrafluorborat 4

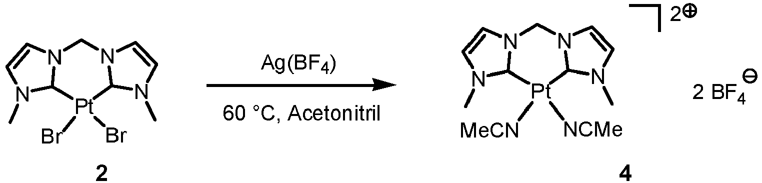

Zu 0,38 mmol (1,1'-Dimethyl-3,3'-methylendiimidazolin-2,2'-diyliden)platin(II)dibromid 2 (0,200 g) werden 0,75 mmol Silbertetrafluorborat (0,147 g) in 6 mL Acetonitril gegeben. Das Gemisch wird unter Lichtausschluss 8 Stunden bei 60 °C gerührt. Das ausfallende Silberbromid wird abfiltriert und das Lösungsmittel wird im Vakuum entfernt. Es entsteht ein weißer Feststoff 4. Das Produkt ist unter Argon zu lagern.

| | | |
|---|---|---|
| Summenformel: | C₉H₁₂N₄B₂F₈Pt | M = 544,910 g/mol |
| Ausbeute: | 0,220 g (100 % d. Th.) | |
| Schmelzpunkt: | Zersetzung bei > 190 °C | |

**¹H-NMR** (ppm, d₆-DMSO, 300,13 MHz): δ = 7,72 (s, 2H, NCHCHN); 7,53 (d, 2H, J = 1,6 Hz, NCHCHN); 6,30 (s, 2H, NCH₂N); 3,88 (s, 6H, CH₃-Gruppe)
**¹³C-NMR** (ppm, d₆-DMSO, 75,475 MHz): δ = 129,10 (C_{Carben}); 123,33 (NCHCHN); 121,79 (NCHCHN); 61,54 (NCH₂N); 36,47 (CH₃-Gruppe)
**¹⁹F-NMR** (ppm, d₆-DMSO, 282,4 MHz): δ = -148,24 (BF₄)
**Elementaranalyse** für C₉H₁₂N₄B₂F₈Pt:

| | | | |
|---|---|---|---|
| C | | H | N |
| berechnet | 19,84 % | 2,22 % | 10,28 % |
| gefunden | 24,82 % | 2,88 % | 12,79 % |

### D) (1,1'-Dimethyl-3,3'-methylendiimidazolin-2,2'-diyliden)platin(II)-2",2‴-biphenolat 5

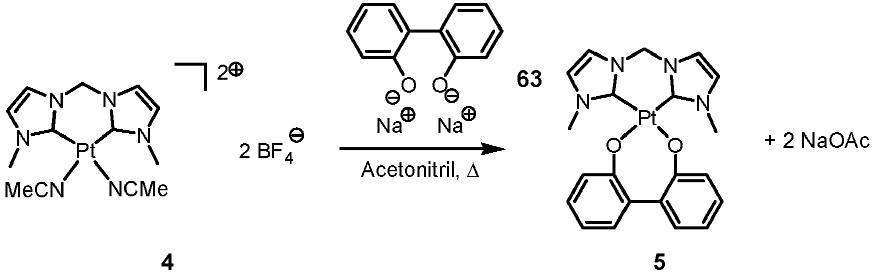

Zu 0,28 mmol (1,1'-Dimethyl-3,3'-methylendiimidazolin-2,2'-diyliden)platin(II)-dite-trafluorborat **4** (0,150 g) werden 0,28 mmol 2,2'-Biphenolatdinatriumsalz **1** (0,063 g) in 5 mL Acetonitril gegeben. Das Gemisch wird 8 Stunden bei 60 °C gerührt. Der ausfallende Feststoff wird abfiltriert und im Vakuum getrocknet. Es entsteht ein weißer Feststoff **5.**

| | | |
|---|---|---|
| **Summenformel:** | C₂₁H₂₀N₄O₂Pt | M = 555,488 g/mol |
| **Ausbeute:** | 0,033 g (21,2 % d. Th.) | |
| **Schmelzpunkt:** | Zersetzung bei > 330 °C | |

**¹H-NMR** (ppm, d₆-DMSO, 300,13 MHz): δ = 7,52 (d, 2H, J = 1,9 Hz, NCHCHN); 7,13 (d, 2H, J = 2,0 Hz, NCHCHN); 7,03 (m, 2H, J = 7,2 Hz, arom. CH); 6,85 (m, 2H, J = 7,3 Hz, arom. CH); 6,76 (m, 2H, J = 7,3 Hz, arom. CH); 6,43 (m, 2H, J = 7,2 Hz, arom. CH); 6,35 (AB, 1H, J = 12,9 Hz, NCH₂N); 6,22 (AB, 1H, J = 13,0 Hz, NCH₂N); 3,33 (s, 6H, CH₃-Gruppe)
**¹³C-NMR** (ppm, d₆-DMSO, 75,475 MHz): δ = 164,63 (Cᵢₚₛₒ-O); 140,99 (C_{Carben}); 132,36 (Cᵢₚₛₒ); 130,20 (arom. CH); 126,82 (arom. CH); 122,16 (NCHCHN); 120,32 (NCHCHN); 118,67 (arom. CH); 114,38 (arom. CH); 61,50 (NCH₂N); 35,01 (CH₃-Gruppe)
**Elementaranalyse** für C₂₁H₂₀N₄O₂Pt:

| | | | |
|---|---|---|---|
| C | | H | N |
| berechnet | 45,40 % | 3,63 % | 10,09 % |
| gefunden | 40,23 % | 3,28 % | 7,83 % |

### Photolumineszenz-Daten

Um den erfindungsgemäßen Übergangsmetallcarbenkomplex weiter im verdünnten Festkörper zu charakterisieren, wird ein entsprechender PMMA (Polymethylmethacrylat)-Film enthaltend 2 Gew.-% des Übergangsmetallkomplexes in PVP hergestellt. Für den PMMA-Film werden 2 mg Übergangsmetallcarbenkomplex 5 in 1 ml 10%ige (Massenprozent) PMMA-Lösung (PMMA in Dichlormethan) gelöst und mit einem 60 µm Rakel ein Film auf einen Objektträger (Quarzglas) ausgestrichen. Der Film wird anschließend getrocknet. Die Photolumineszenz-Daten des Übergangsmetallcarbenkomplexes werden an dem erhaltenen Film ermittelt.
Anregungswellenlänge: 325 nm
Emissionswellenlänge: 469 nm

## Patentansprüche

1. Verwendung von Übergangsmetallcarbenkomplexen der allgemeinen Formel (I) in organischen Leuchtdioden 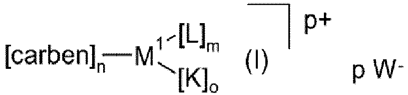 wobei die Symbole die folgenden Bedeutungen aufweisen:
M¹ Metallatom ausgewählt aus der Gruppe bestehend aus Übergangsmetallen der Gruppe IIB, IIIB, IVB, VB, VIB, VIIB, VIII des Periodensystems der Elemente (CAS-Version) und Cu, in jeder für das entsprechende Metallatom möglichen Oxidationsstufe;
K neutraler mono- oder bidentater Ligand;
L mono- oder dianionischer Ligand, der mono- oder bidentat sein kann;
m 0 bis 5;
o 0 bis 5;
n 1 bis 6;
p Ladung des Komplexes: 0, 1, 2, 3, 4;
W⁻ monoanionisches Gegenion;
wobei m, o, n und p von der Oxidationsstufe und Koordinationszahl des eingesetzten Metallatoms und von der Ladung der Liganden und der Gesamtladung des Komplexes abhängig sind,
carben
Carbenligand ausgewählt aus der Gruppe bestehend aus 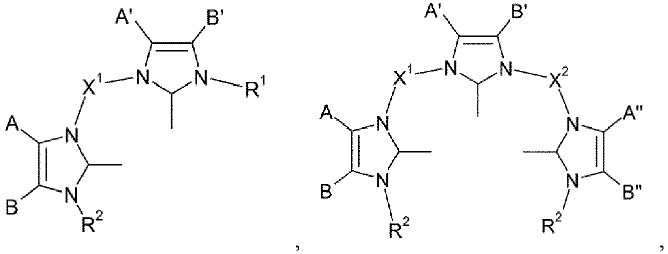 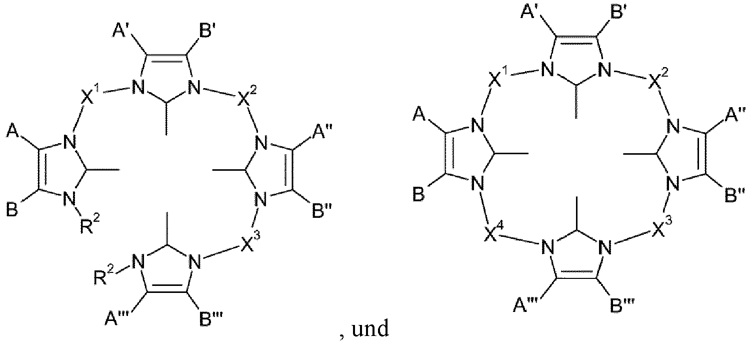 wobei
R¹ und R²
jeweils unabhängig voneinander Wasserstoff, Alkyl, Cycloalkyl, Heterocycloalkyl, Aryl, Heteroaryl, Aralkyl, Alkenyl, Alkinyl, wobei die Gruppen substituiert oder unsubstituiert sein können, BR³₂, NR²²₂, PR²³₂, OR²⁴, SR²⁵ oder SiR⁴₃;
X¹, X², X³, X⁴
unabhängig voneinander CH₂, CH=CH, 1,2-Phenylen;
R³, R⁴, R⁵, R⁶ R⁷, R⁸, R⁸, R⁹, R¹⁰, R¹¹, R²² R²³, R²⁴, R²⁵
unabhängig voneinander Wasserstoff, Alkyl, Cycloalkyl, Heterocycloalkyl, Aryl, Aralkyl, Heteroaryl, Alkenyl, Alkinyl, Alkoxy, wobei die Gruppen substituiert oder unsubstituiert sein können, bevorzugt Wasserstoff, Alkyl, Cycloalkyl, Aryl, Alkoxy, besonders bevorzugt Wasserstoff, Alkyl oder Alkoxy;
R¹², R¹³
unabhängig voneinander Wasserstoff, Alkyl, Cycloalkyl, Heterocycloalkyl, Aryl, Heteroaryl, Aralkyl, Alkinyl, Alkenyl, wobei die Gruppen substituiert oder unsubstituiert sein können, oder Gruppen mit Donor- oder Akzeptorwirkung;
A, A′, Aʺ, A‴
R¹⁸;
B, B', B", B‴
R¹⁹;
wobei R¹⁸ und R¹⁹ Wasserstoff, Alkyl, Cycloalkyl, Heterocycloalkyl, Aryl, Aralkyl, Heteroaryl, Alkinyl, Alkenyl, wobei die Gruppen substituiert oder unsubstituiert sein können, oder eine Gruppe mit Donor- oder Akzeptorwirkung und wobei R¹⁸ in den Gruppen A, A', A", A'" bzw. R¹⁹ in den Gruppen B, B', B", B‴ jeweils die gleichen oder verschiedene Bedeutungen aufweisen können.

2. Verwendung nah Anspruch 1, **dadurch gekennzeichnet, dass** der Übergangsmetallcarbenkomplex ausgewählt ist aus 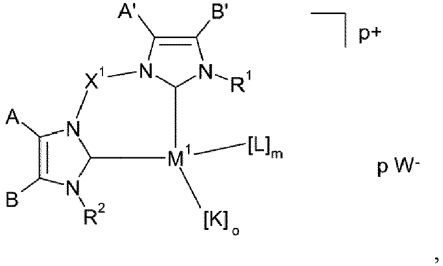 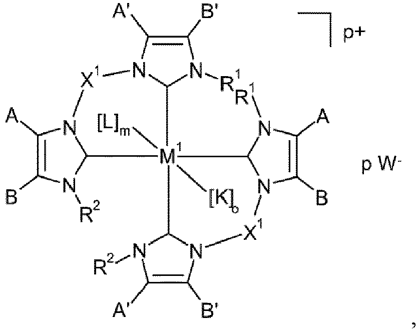 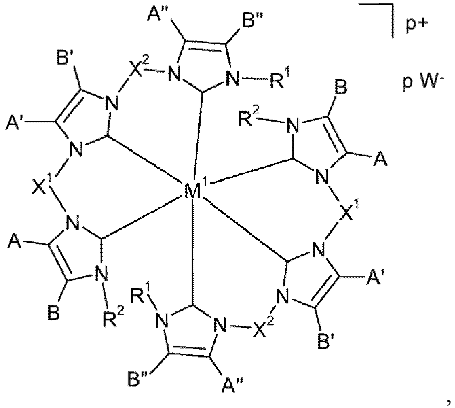 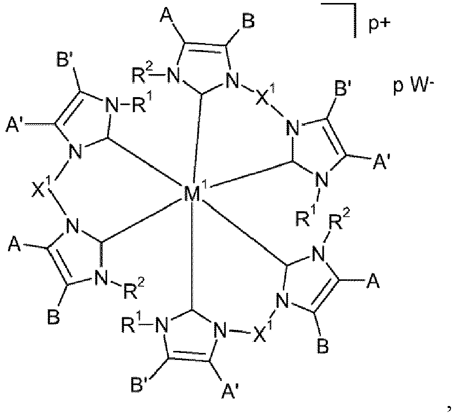 und 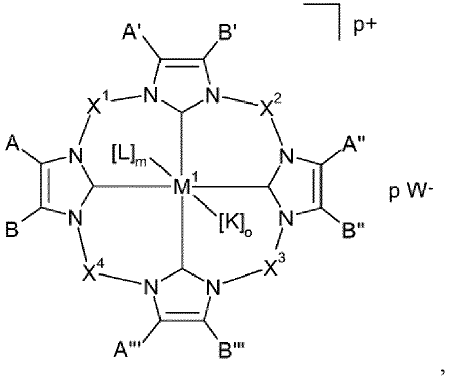 wobei die Symbole die folgenden Bedeutungen aufweisen:
M ¹ Pt, Os, Ru, oder Ir;
K neutraler mono- oder bidentater Ligand;
L Cl ⁻, Br ⁻, I ⁻, OAc ⁻, Alkoholat, Thiolat; oder unsubstituiertes Bisphenolat, unsubstituiertes Bisalkoholat, unsubstituiertes Bisthiolat, unsubstituiertes Bisazolat oder unsubstituiertes Bisamid;
m 0 bis 5;
o 0 bis 5;
p 0, 1, 2, oder 3;
W⁻ Halogenid, Pseudohalogenid oder OAc⁻;
R¹ und R²
unabhängig voneinander substituiertes oder unsubstituiertes Alkyl, substituiertes oder unsubstituiertes Cycloalkyl, oder substituiertes oder unsubstituiertes Aralkyl;
A, A′, Aʺ, A‴
R¹⁸;
B, B', B", B‴
R¹⁹;
wobei R¹⁸ in den Gruppen A, A', A", A‴ bzw. R¹⁹ in den Gruppen B, B', B", B‴ jeweils unabhängig voneinander Wasserstoff oder Gruppen mit Donor-oder Akzeptorwirkung bedeuten;
X¹, X², X³, X⁴
unabhängig voneinander CH₂, CH=CH, 1,2-Phenylen.

3. Organische Leuchtdiode enthaltend mindestens einen Übergangsmetallcarbenkomplex der allgemeinen Formel I gemäß einem der Ansprüche 1 oder 2.

4. Licht-emittierende Schicht enthaltend mindestens einen Übergangsmetallcarbenkomplex der allgemeinen Formel I gemäß einem der Ansprüche 1 oder 2.

5. Organische Leuchtdiode gemäß Anspruch 3, enthaltend mindestens eine Licht-emittierende Schicht gemäß Anspruch 4.

6. Vorrichtung ausgewählt aus der Gruppe bestehend aus stationären Bildschirmen wie Bildschirmen von Computern, Fernsehern, Bildschirmen in Druckern, Küchengeräten sowie Reklametafeln, Beleuchtungen, Hinweistafeln und mobilen Bildschirmen wie Bildschirmen in Handys, Laptops, Digitalkameras, Fahrzeugen sowie Zielanzeigen an Bussen und Bahnen enthaltend mindestens eine organische Leuchtdiode gemäß Anspruch 3 oder 5.

## Claims

1. Use of transition metal carbene complexes represented by formula (I) in organic light-emitting diodes 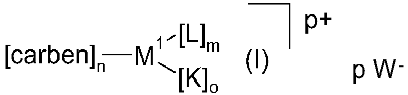 wherein the symbols have the following meanings:
M¹ is a metal atom selected from the group consisting of transition metals of groups IIB, IIIB, IVB, VB, VIB, VIIB, VIII of the Periodic Table of the Elements (CAS-Version) and Cu, each in any oxidation state possible for the corresponding metal atom;
K is an uncharged mono- or bidentate ligand;
L is a mono- or dianionic ligand, which can be mono- or bidentate;
m is from 0 to 5;
o is from 0 to 5;
n is from 1 to 6;
p is the charge of the complex: 0, 1, 2, 3, 4;
W⁻ is a monoanionic counter ion;
wherein m, o, n and p depend on the oxidation state and coordination number of the metal atom utilized and on the charge of the ligands and on the total charge of the complex,
carben is a carbene ligand selected from the group consisting of 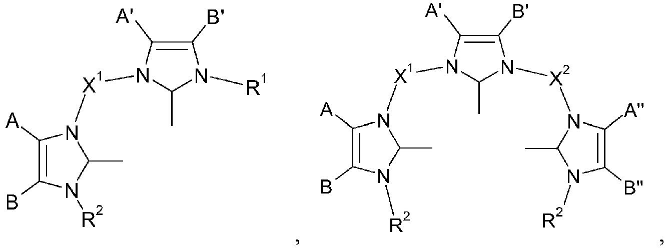 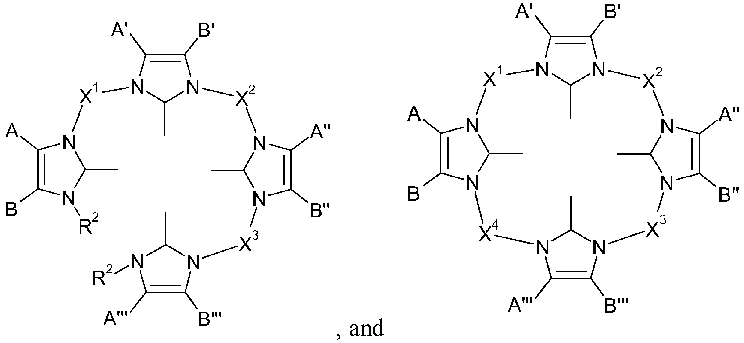 wherein
R¹ and R²
are each independently hydrogen, alkyl, cycloalkyl, heterocycloalkyl, aryl, heteroaryl, aralkyl, alkenyl, alkynyl, wherein the groups can be substituted or unsubstituted, BR³₂, NR²²₂, PR²³₂, OR²⁴, SR²⁵ or SiR⁴₃;
X¹, X², X³, X⁴
are each independently CH₂, CH=CH, 1,2-phenylene;
R³, R⁴, R⁵, R⁶, R⁷, R⁸, R⁸, R⁹, R¹⁰, R¹¹, R²², R²³, R²⁴, R²⁵
are each independently hydrogen, alkyl, cycloalkyl, heterocycloalkyl, aryl, aralkyl, heteroaryl, alkenyl, alkynyl, alkoxy, wherein the groups can be substituted or unsubstituted, preferably hydrogen, alkyl, cycloalkyl, aryl, alkoxy, particularly preferred hydrogen, alkyl or alkoxy;
R¹², R¹³
are each independently hydrogen, alkyl, cycloalkyl, heterocycloalkyl, aryl, aralkyl, heteroaryl, aralkyl, alkynyl, alkenyl, wherein the groups can be substituted or unsubstituted, or groups having donor- or acceptor action;
A, A', A", A‴
are R¹⁸;
B,B′,Bʺ,B‴
are R¹⁹;
wherein R¹⁸ and R¹⁹ are hydrogen, alkyl, cycloalkyl, heterocycloalkyl, aryl, aralkyl, heteroaryl, alkynyl, alkenyl, wherein the groups can be substituted or unsubstituted, or a group having donor- or acceptor action, and wherein R¹⁸ in groups A, A′, A", A‴ or R¹⁹ in groups B, B', B", B‴ is each having the same or different meanings.

2. The use of claim 1, **characterized in that** the transition metal complex is selected from 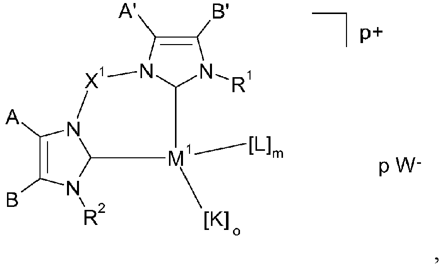 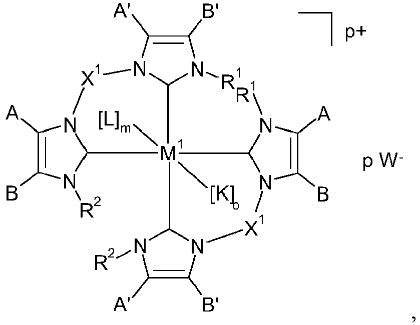 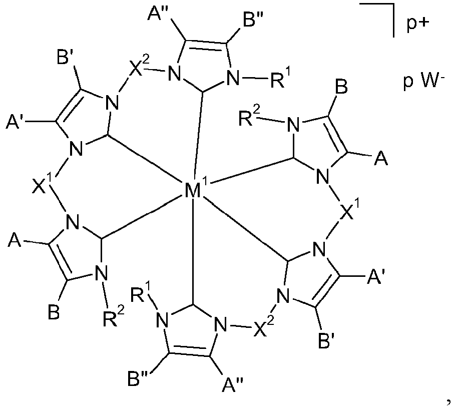 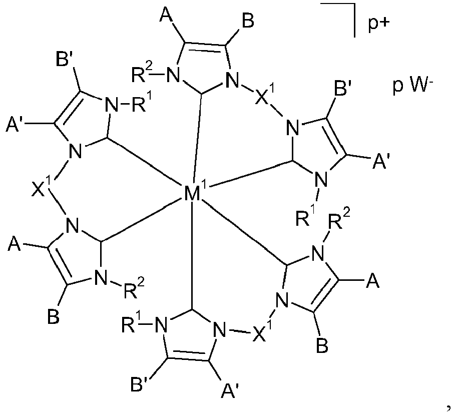 and 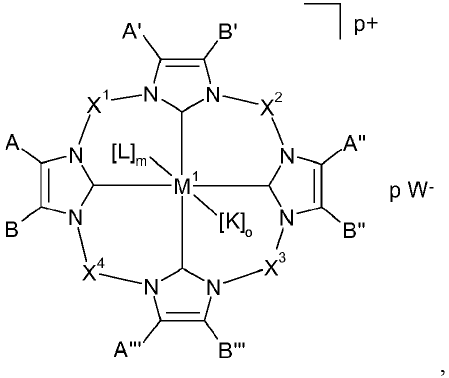 wherein the symbols have the following meanings:
M ¹ is Pt, Os, Ru, or Ir;
K is an uncharged mono- or bidentate ligand;
L is Cl ⁻, Br ⁻, I ⁻, OAc ⁻, alcoholate, thiolate; or unsubstituted bisphenolate, unsubstituted bisalcoholate, unsubstituted bisthiolate, unsubstituted bisazolate or unsubstituted bisamide;
m is from 0 to 5;
o is from 0 to 5;
p is 0, 1, 2, or 3;
W⁻ is halogen, pseudohalogen or OAc⁻;
R¹ and R²
are each independently substituted or unsubstituted alkyl, substituted or unsubstituted cycloalkyl, or substituted or unsubstituted aralkyl;
A, A', A", A‴
is R¹⁸;
B,B′,Bʺ,B‴
is R¹⁹;
wherein R¹⁸ in groups A, A', A", A‴ or R¹⁹ in groups B, B', B", B‴ is each independently hydrogen or groups having donor- or acceptor action;
X¹, x², X³, X⁴
are each independently CH₂, CH=CH, 1,2-phenylene.

3. An organic light-emitting diode comprising at least one transition metal carbene complex represented by formula I according to one of claims 1 or 2.

4. A light-emitting layer comprising at least one transition metal carbene complex represented by formula I according to one of claims 1 or 2.

5. The organic light-emitting diode according to claim 3, comprising at least one light-emitting layer according to claim 4.

6. A device selected from the group consisting of stationary visual display units such as visual display units of computers, televisions, visual display units in printers, kitchen appliances and advertising panels, illuminations, information panels and mobile visual display units, such as visual display units in cellphones, laptops, digital cameras, vehicles and destination displays on buses and trains, and illumination units, comprising at least one organic light-emitting diode according to claim 3 or 5.

## Revendications

1. Utilisation de complexes de carbène-métaux de transition de formule générale (I) dans des diodes électroluminescentes organiques 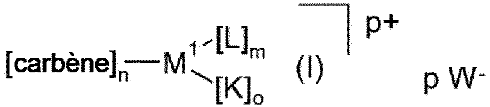 dans laquelle les symboles ont les significations suivantes :
M¹ atome de métal choisi dans le groupe constitué des métaux de transition des groupes IIB, IIIB, IVB, VB, VIB, VIIB, VIII du tableau périodique des éléments (version CAS) et Cu, dans tous les états d'oxydation possibles pour l'atome de métal correspondant ;
K ligand neutre mono- ou bidenté ;
L ligand mono- ou dianionique, qui peut être mono- ou bidenté ;
m de 0 à 5 ;
o de 0 à 5 ;
n de 1 à 6 ;
p charge du complexe : 0, 1, 2, 3, 4 ;
W⁻ contre-ion monoanionique ;
m, o, n et p étant dépendants de l'état d'oxydation et du nombre de coordination de l'atome métallique utilisé et de la charge des ligands et de la charge totale du complexe,
carbène
ligand carbène choisi dans le groupe constitué de 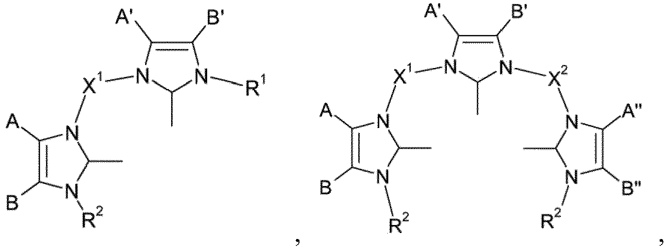 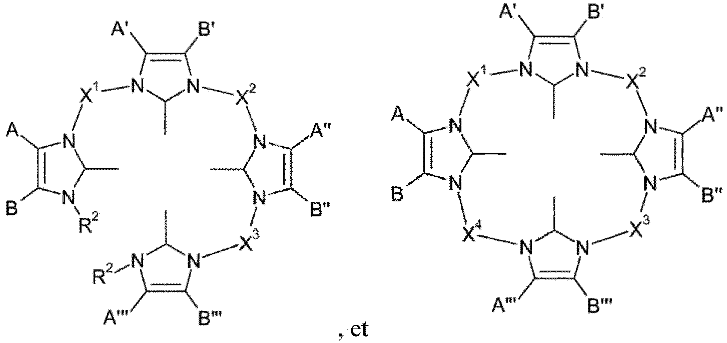
R¹ et R²
étant chacun, indépendamment l'un de l'autre, hydrogène, alkyle, cycloalkyle, hétérocycloalkyle, aryle, hétéroaryle, aralkyle, alcényle, alcynyle, les groupes pouvant être substitués ou non, BR³₂, NR²²₂, PR²³₂, OR²⁴, SR²⁵ ou SiR⁴₃ ;
X¹ X², X³, X⁴
étant, indépendamment les uns des autres, CH₂, CH=CH, 1,2-phénylène ;
R³, R⁴, R⁵, R⁶, R⁷, R⁸, R⁸, R⁹, R¹⁰, R¹¹, R²², R²³, R²⁴, R²⁵
étant, indépendamment les uns des autres, hydrogène, alkyle, cycloalkyle, hétérocycloalkyle, aryle, aralkyle, hétéroaryle, alcényle, alcynyle, alcoxy, les groupes pouvant être substitués ou non substitués, de préférence hydrogène, alkyle, cycloalkyle, aryle, alcoxy, et de manière particulièrement préférée hydrogène, alkyle ou alcoxy ;
R¹², R¹³
étant, indépendamment l'un de l'autre, hydrogène, alkyle, cycloalkyle, hétérocycloalkyle, aryle, hétéroaryle, aralkyle, alcynyle, alcényle, les groupes pouvant être substitués ou non, ou à effet donneur ou accepteur ;
A, A', A", A‴
R¹⁸ ;
B, B', B", B‴
R¹⁹ ;
R¹⁸ et R¹⁹ étant hydrogène, alkyle, cycloalkyle, hétérocycloalkyle, aryle, aralkyle, hétéroaryle, alcynyle, alcényle, les groupes pouvant être substitués ou non substitués, ou être un groupe avec un effet donneur ou accepteur, et R¹⁸ dans les groupes A, A', A", A'" ou R¹⁹ dans les groupes B, B', B", B‴ pouvant avoir chacun la même signification ou des significations différentes.

2. Utilisation selon la revendication 1, **caractérisée en ce que** le complexe carbène-métal de transition est choisi parmi 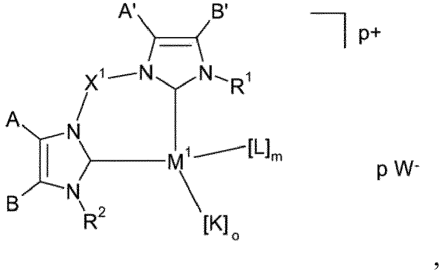 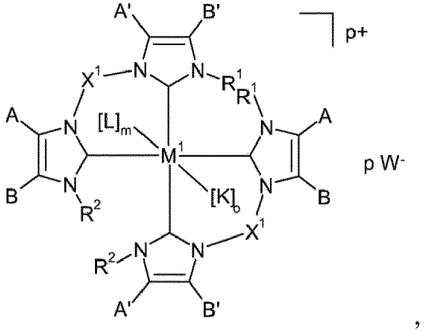 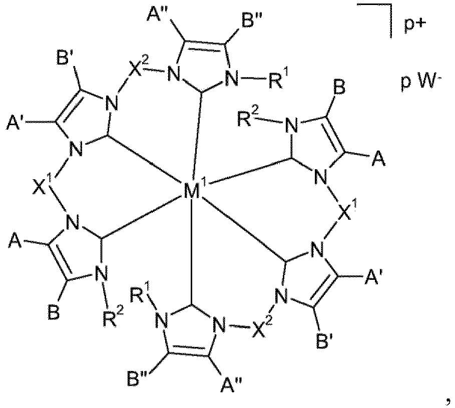 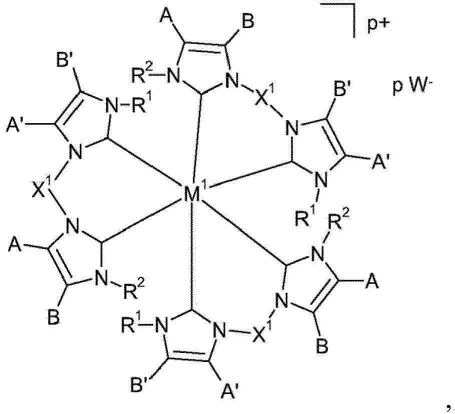 et 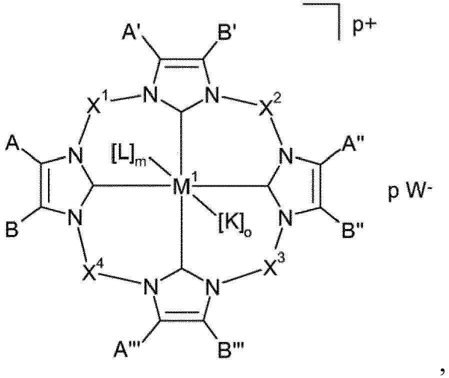 dans lesquelles les symboles ont les significations suivantes :
M¹ Pt, Os, Ru ou Ir ;
K ligand neutre mono- ou bidenté ;
L Cl ⁻, Br ⁻, I ⁻ , OAc ⁻, alcoolate, thiolate ; ou bisphénolate non substitué, bisalcoolate non substitué, bisthiolate non substitué, bisazolate non substitué ou bisamide non substitué ;
m de 0 à 5 ;
o de 0 à 5 ;
p 0, 1,2 ou 3 ;
W⁻ halogénure, pseudohalogénure ou OAc ⁻ ;
R¹ et R²
étant, indépendamment l'un de l'autre, alkyle substitué ou non substitué, cycloalkyle substitué ou non substitué, ou aralkyle substitué ou non substitué ;
A, A', A ", A‴
R¹⁸;
B, B', B ", B'"
R¹⁹;
R¹⁸ dans les groupes A, A', A", A'" ou R¹⁹ dans les groupes B, B', B", B'" étant chacun, indépendamment l'un de l'autre, de l'hydrogène ou des groupes à effet donneur ou accepteur ;
X¹, X², X³, X⁴
étant indépendamment les uns des autres CH₂, CH=CH, 1,2-phénylène.

3. Diode électroluminescente organique contenant au moins un complexe carbène-métal de transition de formule générale I selon l'une des revendications 1 ou 2.

4. Couche électroluminescente contenant au moins un complexe carbène-métal de transition de formule générale I selon l'une des revendications 1 ou 2.

5. Diode électroluminescente organique selon la revendication 3, contenant au moins une couche électroluminescente selon la revendication 4.

6. Appareil sélectionné dans le groupe constitué par les écrans fixes tels que les écrans d'ordinateurs, de téléviseurs, les écrans d'imprimantes, d'appareils de cuisine et de panneaux publicitaires, d'éclairages, de panneaux indicateurs et par les écrans mobiles tels que les écrans de téléphones portables, d'ordinateurs portables, d'appareils photo numériques, de véhicules et d'affichages ciblés sur les bus et les trains, contenant au moins une diode électroluminescente organique selon la revendication 3 ou 5.
